# EUROPEAN PATENT APPLICATION

(11) **EP 4 521 903 A1**
(43) Date of publication of application: **12.03.2025**
(21) Application number: 24194842.1
(22) Date of filing: 16.08.2024
(51) Int. Cl.: H10K 59/80, G02F 1/1333

(54) **DISPLAY APPARATUS AND METHOD OF MANUFACTURING THE SAME**

(30) Priority: 05.09.2023 KR 20230117427
(71) Applicant: Samsung Display Co., Ltd., Gyeonggi-do 17113 (KR)
(72) Inventor: Kim, Jungwook, 17113 Yongin-si, Gyeonggi-do (KR); Mun, Eunjoong, 17113 Yongin-si, Gyeonggi-do (KR); Kim, Eunki, 17113 Yongin-si, Gyeonggi-do (KR); Park, Kyounghee, 17113 Yongin-si, Gyeonggi-do (KR); Hwang, Hyeondeuk, 17113 Yongin-si, Gyeonggi-do (KR)
(74) Representative: Gulde & Partner

(57) **Abstract**

A display apparatus according to one or more embodiments of the disclosure includes a display panel (10), a first cover plate (P1) covering an upper surface of the display panel (10) and including a step portion (SP) disposed at an edge portion of the first cover plate (P1), a second cover plate (P2) covering a lower surface of the display panel (10) and including a protrusion portion (PP) disposed on an upper surface of the second cover plate (P2) and not overlap the first cover plate (P1), and a side-surface covering member (20) at least partially covering a portion of a side surface of the display panel (10) which is exposed between the step portion (SP) and the protrusion portion (PP).

## Description

### BACKGROUND

### 1. Technical Field

One or more embodiments of the disclosure relate to a display apparatus and a method of manufacturing the display apparatus, and more particularly, to a display apparatus capable of preventing interference between a side-surface covering member formed on a side surface of a display panel and a fastening member, and a method of manufacturing the display apparatus.

### 2. Description of the Related Art

Display apparatuses are apparatuses that receive input of information regarding images and display images. Display apparatuses are used as display units of small-sized products such as mobile phones, and are also used as display units of large-sized products such as televisions.

A display apparatus may include pixels that receive electrical signals and emit light to display images to the outside. Each of the pixels may include a light-emitting diode. For example, an organic light-emitting diode display apparatus may include an organic light-emitting diode (OLED) as a light-emitting diode. Generally, in organic light-emitting display apparatuses, a thin-film transistor and an organic light-emitting diode may be formed on a substrate, and the organic light-emitting diode may autonomously emit light.

Such a display apparatus may include a side-surface covering member formed on a side surface of a display panel, and the side-surface covering member may undergo interference with a fastening member.

### SUMMARY

One or more embodiments of the disclosure include a display apparatus capable of preventing interference between a side-surface covering member formed on a side surface of a display panel and a fastening member, and a method of manufacturing the display apparatus. However, the aforementioned goals are only examples, and the scope of embodiments are not limited thereto.

Additional aspects will be set forth in part in the description which follows and, in part, will be apparent from the description, or may be learned by practice of the embodiments of the disclosure.

According to one or more embodiments of the disclosure, a display apparatus may include a display panel, a first cover plate covering an upper surface (e.g., a top surface) of the display panel and including a step portion disposed at an edge portion of the first cover plate (e.g., at an edge portion of the display panel), a second cover plate covering a lower surface (e.g., a bottom surface) of the display panel, a protrusion portion disposed on an upper surface (e.g., a top surface) of the second cover plate (e.g., at the edge portion of the display panel) and not overlapping the first cover plate when viewed in a direction perpendicular to the display panel, and a side-surface covering member at least partially covering a portion of a side surface of the display panel which is exposed between the step portion and the protrusion portion.

The step portion may have a step shape having a height decreasing from inside the first cover plate toward outside the first cover plate.

A covering area of the side-surface covering member may be partially defined by an inner surface of the step portion and an outer surface of the protrusion portion.

The protrusion portion may protrude with respect to the upper surface of the second cover plate, and may include a light-blocking material.

The side-surface covering member may further cover at least a portion of an inner surface of the step portion and a lower surface of the step portion.

The side-surface covering member may further cover a portion of the upper surface of the second cover plate which is exposed between the display panel and the protrusion portion.

The display apparatus may further include an adhesive layer disposed between the second cover plate and the display panel.

The display apparatus may further include a fastening member which contacts the first cover plate and the second cover plate, and which may not be interfered by the side-surface covering member in case that the fastening member contacts the first cover plate and the second cover plate.

In case that the fastening member is fastened, the side-surface covering member may be spaced apart from the fastening member by the step portion.

In case that the fastening member is fastened, the side-surface covering member may be spaced apart from the fastening member by the protrusion portion.

The second cover plate may include a transparent material, and light emitted from the display panel may be transmitted through the second cover plate and emitted outside.

The display apparatus may further include a light-blocking material layer disposed between the protrusion portion and the second cover plate, and including a light-blocking material, and the protrusion portion may be disposed on the light-blocking material layer.

When viewed in a direction perpendicular to the display panel, an inner surface of the step portion may be disposed further inward than the side surface of the display panel.

An edge portion of the side-surface covering member may contact at least a portion of an inner surface of the step portion.

The edge portion of the side-surface covering member may have a shape corresponding to a shape of the inner surface of the step portion.

Another edge portion of the side-surface covering member may contact at least a portion of the inner surface of the protrusion portion.

The another edge portion of the side-surface covering member may have a shape corresponding to a shape of the inner surface of the protrusion portion.

According to one or more embodiments of the disclosure, a method of manufacturing a display apparatus may include attaching a first cover plate on an upper surface (e.g., a top surface) of a display panel, attaching a second cover plate on a lower surface (e.g., a bottom surface) of the display panel by using an adhesive layer, forming a step portion by removing a portion of an edge portion of the first cover plate, forming a protrusion portion on an upper surface (e.g., a top surface) of the second cover plate, and forming a side-surface covering member by applying a strength-enhancing material on a portion of a side surface of the display panel which is exposed between the step portion and the protrusion portion.

When viewed in a direction perpendicular to the display panel, the protrusion portion may be disposed in an area where the first cover plate and the second cover plate do not overlap each other.

A covering area of the side-surface covering member on an upper surface of the first cover plate may be limited by the step portion.

A covering area of the side-surface covering member on an upper surface of the second cover plate may be limited by the protrusion portion.

The manufacturing method may further include fastening the first cover plate and the second cover plate by a fastening member, preferably without (e.g., configured to avoid) interference with the side-surface covering member.

According to one or more embodiments of the disclosure, a display apparatus may include a display panel, a first cover plate covering an upper surface (e.g., a top surface) of the display panel, and a second cover plate covering a lower surface (e.g., a bottom surface) of the display panel, and a side-surface covering member covering at least a portion of a side surface of the display panel and at least a portion of an edge portion of an upper surface (e.g., a top surface) of the first cover plate and including an edge portion having a step portion on the upper surface (e.g., a top surface) of the first cover plate (e.g., at an edge portion of the display panel).

The side-surface covering member may cover a portion of an upper surface of the second cover plate, and another edge portion of the side-surface covering member may have a step portion on an upper surface of the second cover plate.

The display apparatus may further include a light-blocking material layer disposed between the another edge portion of the side-surface covering member and the upper surface of the second cover plate.

According to one or more embodiments of the disclosure, a method of manufacturing a display apparatus may include attaching a first cover plate on an upper surface (e.g., a top surface) of a display panel, attaching a second cover plate on a lower surface (e.g., a bottom surface) of the display panel by using an adhesive layer, forming a step portion with respect to an upper surface (e.g., a top surface) of the first cover plate by attaching a first protective layer on the upper surface (e.g., a top surface) of the first cover plate, the step portion and the first protective layer having a same thickness, forming a protrusion portion protruding with respect to an upper surface (e.g., a top surface) of the second cover plate by attaching a second protective layer to an area of the upper surface (e.g., a top surface) of the second cover plate which is exposed upward, the protrusion portion and the second protective layer having a same thickness, forming a side-surface covering member by applying a strength-enhancing material on a portion of a side surface of the display panel which is exposed between the step portion and the protrusion portion, and removing the first protective layer or the second protective layer after the forming of the side-surface covering member.

When viewed in a direction perpendicular to the display panel, the protrusion portion may be disposed in an area where the first cover plate and the second cover plate do not overlap each other.

A covering area of the side-surface covering member on an upper surface of the first cover plate may be limited by the step portion.

A covering area of the side-surface covering member on an upper surface of the second cover plate may be limited by the protrusion portion.

The method may further include fastening the first cover plate and the second cover plate by a fastening member, preferably without (e.g., configured to avoid) interference with the side-surface covering member.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view schematically illustrating a display panel of a display apparatus according to an embodiment;
FIG. 2 is a schematic diagram of an equivalent circuit diagram of a pixel included in the display panel shown in FIG. 1;
FIG. 3 is a schematic cross-sectional view schematically illustrating a portion of the display panel shown in FIG. 1;
FIG. 4 is a schematic cross-sectional view schematically illustrating a portion of a display apparatus according to a first embodiment of the disclosure;
FIG. 5 is a schematic cross-sectional view schematically illustrating a portion of a display apparatus according to a first embodiment of the disclosure;
FIG. 6 is a schematic plan view schematically illustrating an example in which a structure shown in the cross-sectional view of FIG. 5 is applicable in a display panel only partially shown with respect to a first axis shown in FIG. 1;
FIG. 7 is a schematic plan view schematically illustrating an example in which a structure shown in the cross-sectional view of FIG. 5 is applicable in a display panel only partially shown with respect to a second axis shown in FIG. 1;
FIG. 8 is a schematic cross-sectional view schematically illustrating some operations of a method of manufacturing the display apparatus according to the first embodiment;
FIG. 9 is a schematic plan view schematically illustrating an example in which a structure shown in the cross-sectional view of FIG. 8 is applicable in a display panel only partially shown with respect to the first axis shown in FIG. 1;
FIG. 10 is a schematic plan view schematically illustrating another example in which the structure shown in the schematic cross-sectional view of FIG. 8 is applicable in a display panel only partially shown with respect to the second axis shown in FIG. 1; FIGS. 11 and 12 are cross-sectional views each schematically illustrating a part of an operation of the method of manufacturing the display apparatus according to a second embodiment;
FIG. 13 is a schematic plan view schematically illustrating an example in which a structure of the schematic cross-sectional view shown in FIG. 11 is applicable in a display panel only partially shown with respect to the first axis shown in FIG. 1;
FIG. 14 is a schematic plan view schematically illustrating another example in which the structure of the schematic cross-sectional view shown in FIG. 11 is applicable in a display panel only partially shown with respect to the second axis shown in FIG. 1;
FIGS. 15 and 16 are schematic cross-sectional views each schematically illustrating a portion of a display apparatus according to a comparative example.
FIG. 17 is a cross-sectional view schematically illustrating a portion of a display apparatus according to another comparative example;
FIGS. 18 and 19 are schematic cross-sectional views each schematically illustrating a portion of a display apparatus according to another comparative example;
FIG. 20 is a schematic rear view schematically illustrating a display apparatus according to a first embodiment or a second embodiment; and
FIG. 21 is a graph showing a result of comparing peel strengths according to positions of the side-surface covering member of the display apparatus shown in FIG. 20.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. An x-axis, a y-axis, and a z-axis are not limited to three axes on an orthogonal coordinate system, and may be interpreted as a wide meaning including the same. For example, the x-axis, y-axis, and z-axis may be orthogonal to one another, but may also refer to different directions that are not orthogonal to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, a display apparatus according to an embodiment will be described as follows based on the descriptions written above.

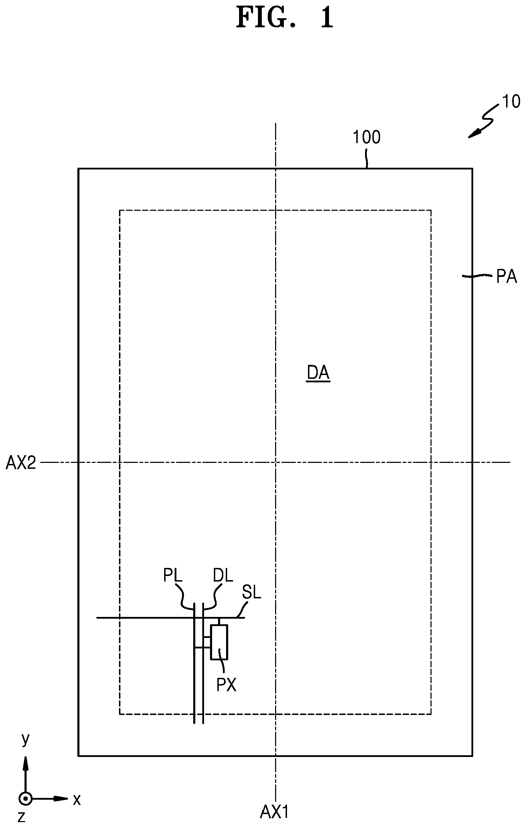

FIG. 1 is a schematic plan view schematically illustrating a display panel 10 of a display apparatus according to an embodiment.

As shown in FIG. 1, the display apparatus according to an embodiment may include the display panel 10. The display apparatus may include any display apparatus including the display panel 10. For example, the display apparatus may include various types of apparatuses such as smartphones, tablet computers, laptop computers, televisions, billboard charts, and the like. For example, the display apparatus according to an embodiment may include thin-film transistors, a capacitor, and the like, which are formed by such conductive layers and insulating layers.

The display panel 10 may include a display area DA and a peripheral area PA positioned outside the display area DA. FIG. 1 illustrates that the display area DA has a rectangular shape. However, embodiments are not limited thereto. The display area DA may have various shapes, for example, a circle shape, an ellipse shape, a polygon shape, or shapes of other figures.

Pixels PX may be arranged in the display area DA, which displays images. Each of the pixels PX may include a display device such as an organic light-emitting diode. Each of the pixels PX may include, e.g., light of red, green, or blue color. The pixel PX may be connected to a pixel circuit including a thin-film transistor (TFT), a storage capacitor, and the like. The pixel circuit may be connected to a scan line SL, which transfers a scan signal, a data line DL, which crosses the scan line SL and transfers a data signal, a driving voltage line PL, which supplies a driving voltage, and the like. The scan line SL may extend in an x-axis direction (hereinafter, referred to as a second direction), and the data line DL and the driving voltage line PL may extend in a y-axis direction (hereinafter, referred to as a first direction).

The pixel PX may emit light of luminance corresponding to electrical signals transferred from pixel circuits electrically connected to the pixel PX. The display area DA may display images through light emitted from the pixel PX. For reference, as described above, the pixel PX may be defined as an emission area from which light of red, green, and/or blue is emitted.

The peripheral area PA, in which the pixels PX are not arranged, may include an area in which images are not displayed. Power supply wirings and the like for driving the pixels PX may be positioned in the peripheral area PA. For example, in the peripheral area PA, pads may be arranged, and a printed circuit board including a driving circuit unit or an integrated circuit device such as a driver integrated circuit (IC) may be electrically connected to the pads.

As the display panel 10 includes a substrate 100, it may be referred that the substrate 100 has the display area DA and the peripheral area PA. Details regarding the substrate 100 will be described later.

Transistors may be arranged in the display area DA. According to types (N type or P type) and/or operation conditions of the transistors, a first terminal of the transistor may include a source electrode or a drain electrode, and a second terminal may include an electrode different from the electrode of the first terminal. For example, in case that the first terminal includes a source electrode, the second terminal may include a drain electrode.

The transistors may include a driving transistor Td, a data write transistor Ts, a compensation transistor, an initialization transistor, an emission control transistor, and the like. The driving transistor Td may be connected between a driving voltage line PL and an organic light-emitting diode OLED, the data write transistor Ts may be connected to the data line DL and the driving transistor Td and may perform a switching operation to supply a data signal Dm transferred from the data line DL.

The compensation transistor may compensate for a threshold voltage of the driving transistor Td by being turned on in response to a scan signal Sn transferred through the scan line SL and by connecting the driving transistor Td and the organic light-emitting diode OLED.

The initialization transistor may initialize a gate electrode of the driving transistor Td by being turned on in response to the scan signal Sn transferred through the scan line SL and by supplying an initialization voltage to the gate electrode of the driving transistor Td. Another scan line may be connected to the initialization transistor, and may be different from the scan line SL connected to the compensation transistor.

The emission control transistor may be turned on in response to an emission control signal transferred through an emission control line. Thus, a driving current may flow through the organic light-emitting diode OLED.

The organic light-emitting diode OLED may include a pixel electrode (e.g., an anode) 150 and a counter electrode (e.g., a cathode) 170, and a second power voltage ELVSS may be applied (or disposed) to the counter electrode 170. The organic light-emitting diode OLED may display images by receiving a driving current from the driving transistor Td and emitting light.

Hereinafter, an organic light-emitting display apparatus will be described as an example of the display apparatus according to an embodiment. However, embodiments are not limited thereto. In another embodiment, the display apparatus according to the disclosure may include a display apparatus, e.g., an inorganic light-emitting display apparatus or a quantum-dot light-emitting display apparatus. For example, an emission layer of a display device included in the display apparatus may include an organic material or an inorganic material. For example, the display apparatus may include an emission layer and quantum dots positioned on a path of light emitted from the emission layer.

In plan view, virtual axes partitioning the display panel 10 may be shown. A first axis AX1 is a virtual line, which partitions the display panel 10 in an x-axis direction, and the display panel 10 may be symmetrical or almost symmetrical with reference to the first axis AX1. For convenience of explanation, characteristics of the display panel 10 divided with reference to the first axis AX1 will be described.

A second axis AX2 is a virtual line, which partitions the display panel 10 in a y-axis direction, and the display panel 10 may be symmetrical or almost symmetrical with reference to the second axis AX2. For convenience of explanation, characteristics of the display panel 10 divided with reference to the second axis AX2 will be described.

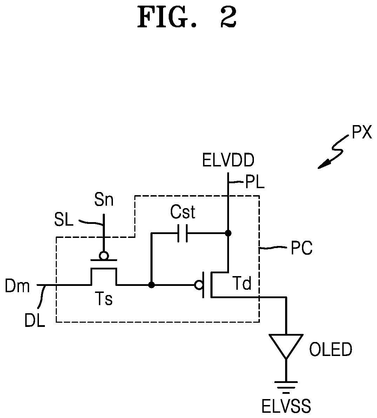

FIG. 2 is a schematic diagram of an equivalent circuit diagram of one of the pixels PX included in the display panel 10 shown in FIG. 1.

As shown in FIG. 2, each pixel PX may include a pixel circuit PC, which is connected to a scan line SL and a data line DL, and an organic light-emitting diode OLED connected to the pixel circuit PC.

The pixel circuit PC may include a driving transistor Td, a switching transistor Ts, and a storage capacitor Cst. The switching transistor Ts may be connected to the scan line SL and the data line DL, and may supply a data signal Dm input through the data line DL to the driving transistor Td, in response to a scan signal Sn input through the scan line SL.

The storage capacitor Cst may be connected to the switching transistor Ts and the driving voltage line PL, and may store a voltage corresponding to a difference between the voltage transferred from the switching transistor Ts and a first power voltage ELVDD transferred to the driving voltage line PL.

The second power voltage ELVSS may include a driving voltage having a voltage level relatively lower than a voltage level of the first power voltage ELVDD. A voltage level of the driving voltage provided to each pixel PX may correspond to a difference between the voltage levels of the first power voltage ELVDD and the second power voltage ELVSS.

The driving transistor Td may be connected to the driving voltage line PL and the storage capacitor Cst, and may control a driving current flowing from the driving voltage line PL through the organic light-emitting diode OLED, in response to the level of the voltage stored in the storage capacitor Cst. The organic light-emitting diode OLED may emit light of corresponding luminance due to the driving current.

Although FIG. 2 illustrates a case in which the pixel circuit PC includes two thin-film transistors and one storage capacitor, embodiments are not limited thereto. The pixel circuit PC may also include two or more storage capacitors.

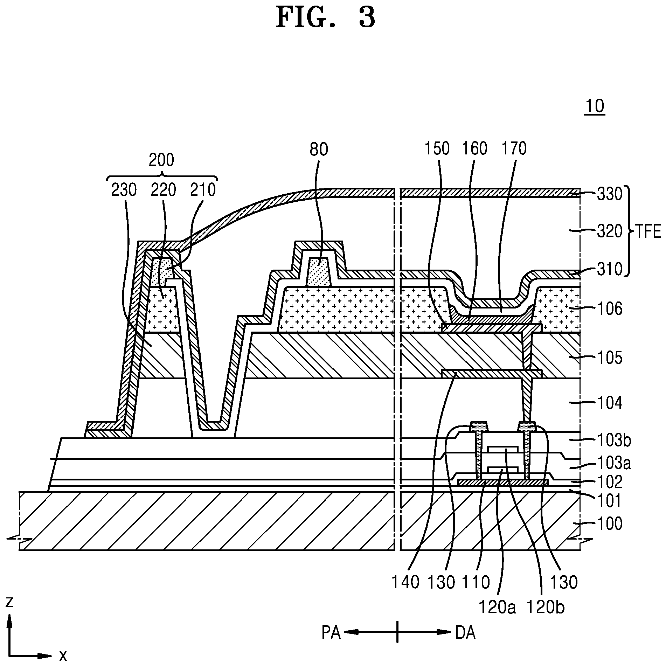

FIG. 3 is a schematic cross-sectional view schematically illustrating a portion of the display panel 10 shown in FIG. 1.

As described above, the substrate 100 may include areas corresponding to the display area DA and the peripheral area PA outside the display area DA. The substrate 100 may include various materials being flexible or bendable. For example, the substrate 100 may include glass, a metal, or a polymer resin. For example, the substrate 100 may include a polymer resin, e.g., polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may also be variously modified, for example, the substrate 100 may have a multi-layered structure including two layers each including the aforementioned polymer resin and a barrier layer between the two layers. For example, the barrier layer may include an inorganic material, e.g., silicon oxide, silicon nitride, silicon oxynitride, and the like.

A buffer layer 101 may be disposed on the substrate 100. The buffer layer 101 may prevent diffusion of impurity ions and permeation of moisture and/or external air, and may function as a barrier layer for planarizing a surface of the substrate 100, and/or a blocking layer. The buffer layer 101 may include silicon oxide, silicon nitride, and/or silicon oxynitride. For example, during a crystallization process for forming a semiconductor layer 110, the buffer layer 101 may adjust the supply rate of heat such that the semiconductor layer 110 is uniformly crystallized.

The semiconductor layer 110 may be disposed on the buffer layer 101. The semiconductor layer 110 may include polysilicon, and may include a channel region, which is not doped with impurities and a source region and a drain region which are formed by doping with impurities and disposed at sides (e.g., opposite sides) of the channel region. For example, the impurities may vary according to types of the thin-film transistors, and may include N-type impurities (or N-type dopants) or P-type impurities (P-type dopants).

A gate insulating layer (or gate insulating film) 102 may be disposed on the semiconductor layer 110. The gate insulating layer 102 may be a configuration to ensure the insulability between the semiconductor layer 110 and a gate layer 120. The gate insulating layer 102 may include an inorganic material such as silicon oxide, silicon nitride, and/or silicon oxynitride, and may be disposed between the semiconductor layer 110 and the gate layer 120. For example, the gate insulating layer 102 may have the form/shape corresponding to an entire surface of the substrate 100, and may also have a structure in which contact holes are formed in certain portions. For example, an insulating layer including an inorganic material may be formed by a chemical vapor deposition (CVD) process or an atomic layer deposition (ALD) process. Same descriptions will be applied to the following embodiments and modifications thereof for descriptive convenience.

A first gate layer 120a may be disposed on the gate insulating layer 102. The first gate layer 120a may be disposed to overlap (e.g., vertically overlap) the semiconductor layer 110, and may include at least one metal from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), titanium (Ti), tungsten (W), and copper (Cu).

A first interlayer insulating layer (or first interlayer insulating film) 103a may be disposed on the first gate layer 120a. The first interlayer insulating layer 103a may cover the first gate layer 120a. The first interlayer insulating layer 103a may include an inorganic material. For example, the first interlayer insulating layer 103a may include a metal oxide and/or a metal nitride. For example, the inorganic material may include silicon oxide (SiO₂), silicon nitride (SiNₓ), silicon oxynitride, aluminum oxide (Al₂O₃), titanium oxide (TiO₂), tantalum oxide (Ta₂O₅), hafnium oxide (HfO₂), zinc oxide (ZnO₂), or the like. In some embodiments, the first interlayer insulating layer 103a may have a double-layered structure including SiOₓ/SiN_{y} or SiNₓ/SiO_{y}.

A second gate layer 120b may be disposed on the first interlayer insulating layer 103a. The second gate layer 120b may be disposed to overlap (e.g., vertically overlap) the first gate layer 120a, and may include at least one metal from among Mo, Al, Pt, Pd, Ag, Mg, Au, Ni, Nd, Ir, Cr, Li, Ca, Ti, W, and Cu.

The second gate layer 120b and the first gate layer 120a may together form the storage capacitor Cst described above with reference to FIG. 2. The first gate layer 120a may include an electrode of the storage capacitor Cst, and the second gate layer 120b may include another electrode of the storage capacitor Cst.

When viewed in a direction perpendicular to the substrate 100, an area (or size) of the second gate layer 120b may be greater than an area (or size) of the first gate layer 120a. For example, when viewed in a direction perpendicular to the substrate 100, the second gate layer 120b may cover (e.g., entirely cover) the first gate layer 120a.

A second interlayer insulating layer (or second interlayer insulating film) 103b may be disposed on the second gate layer 120b. The second interlayer insulating layer 103b may cover the second gate layer 120b. The second interlayer insulating layer 103b may include an inorganic material. For example, the second interlayer insulating layer 103b may include a metal oxide or a metal nitride. For example, the inorganic material may include SiO₂, SiNₓ, SiON, Al₂O₃, TiO₂, Ta₂O₅, HfO₂, ZnO₂, or the like. In some embodiments, the second interlayer insulating layer 103b may have a double-layered structure including SiOₓ/SiN_{y} or SiNₓ/SiO_{y}.

A first conductive layer 130 may be disposed on the second interlayer insulating layer 103b. The first conductive layer 130 may function as an electrode of the source/drain region of the semiconductor layer 110 through a through hole included in the second interlayer insulating layer 103b. The first conductive layer 130 may include one or more metals selected from among Al, Pt, Pd, Ag, Mg, Au, Ni, Nd, Ir, Cr, Li, Ca, Mo, Ti, W, and Cu. For example, the first conductive layer 130 may include a Ti layer, an Al layer, and/or a Cu layer.

A first organic insulating layer 104 may be disposed on the first conductive layer 130. The first organic insulating layer 104 may cover an upper surface of the first conductive layer 130, may have a top surface (or upper surface) that is substantially planar, and may function as a planarization layer. The first organic insulating layer 104 may include an organic insulating layer. The first organic insulating layer 104 may include an organic material, e.g., acryl, benzocyclobutene (BCB), or hexamethyldisiloxame (HMDSO). The first organic insulating layer 104 may be variously changed, for example, may be formed as a single layer or multiple layers.

A second conductive layer 140 may be disposed on the first organic insulating layer 104. The second conductive layer 140 may function as an electrode connected to the source/drain region of the semiconductor layer 110 through a through hole included in the first organic insulating layer 104. The second conductive layer 140 may include one or more metals selected from among Al, Pt, Pd, Ag, Mg, Au, Ni, Nd, Ir, Cr, Li, Ca, Mo, Ti, W, and Cu. For example, the second conductive layer 140 may include a Ti layer, an Al layer, and/or a Cu layer.

A second organic insulating layer 105 may be disposed on the second conductive layer 140. The second organic insulating layer 105 may cover the upper surface of the second conductive layer 140, may have a top surface (or upper surface) that is substantially planar, and may function as a planarization layer. The second organic insulating layer 105 may include an organic insulating layer. The second organic insulating layer 105 may include an organic material, e.g., acryl, BCB, or HMDSO. The second organic insulating layer 105 may be variously changed, and may be formed as a single layer or multiple layers.

For example, additional conductive layers and additional insulating layers may be disposed between conductive layers and pixel electrodes, and may be applied as various embodiments. For example, the additional conductive layers and the conductive layers may include a same material, may have a same layer structure. The additional insulating layers and the organic insulating layers may include a same material, and may have a same layer structure.

A pixel electrode 150 may be disposed on the second organic insulating layer 105. The pixel electrode 150 may be connected to the second conductive layer 140 through a contact hole formed in the second organic insulating layer 105. A display device may be disposed on the pixel electrode 150. The organic light-emitting diode OLED may be used as the display device. For example, the organic light-emitting diode OLED may be, for example, on the pixel electrode 150. The pixel electrode 150 may include a light-transmitting conductive layer including light-transmitting conductive oxides such as ITO, In₂O₃, or IZO, and a reflective layer including metals such as Al or Ag. For example, the pixel electrode 150 may include a three-layered structure including ITO/Ag/ITO.

A pixel defining layer 106 may be disposed on the second organic insulating layer 105 and may be disposed to cover an edge portion of the pixel electrode 150. For example, the pixel defining layer 106 may cover the edge portion of the pixel electrode 150. The pixel defining layer 106 may include an opening corresponding to the pixel PX, and the opening may be formed to expose at least a center portion of the pixel electrode 150. The pixel defining layer 106 may include an organic material, e.g., polyimide or HMDSO. For example, a spacer 80 may be disposed on the pixel defining layer 106.

Although the spacer 80 is illustrated as being disposed on the peripheral area PA, the spacer 80 may also be disposed on the display area DA. The spacer 80 may prevent damage to the organic light-emitting diode OLED due to sagging (or bending) of a mask during a manufacturing process where the mask is used. The spacer 80 may include an organic insulating material, and may be formed as a single layer or multiple layers.

An intermediate layer 160 and a counter electrode 170 may be disposed on the opening of the pixel defining layer 106. The intermediate layer 160 may include a low-molecular material or a high-molecular material. In case that the intermediate layer 160 includes the low-molecular material, the intermediate layer 160 may include a hole injection layer, a hole transport layer, an emission layer, an electron transport layer, and/or an electron injection layer. In case that the intermediate layer 160 includes the high-molecular material, the intermediate layer 160 may usually have a structure including the hole transport layer and the emission layer.

The counter electrode 170 may include a light-transmitting conductive layer formed of a light-transmitting conductive oxide such as ITO, In₂O₃, or IZO. The pixel electrode 150 may be used as an anode, and the counter electrode 170 may be used as a cathode. The polarity of the pixel electrode 150 and the counter electrode 170 may be applied in reverse.

The intermediate layer 160 is not limited to the aforementioned structure, and may have various structures. For example, at least one of layers of the intermediate layer 160 may be integrally formed, like the counter electrode 170. In another embodiment, the intermediate layer 160 may include layers patterned to respectively correspond to a plurality of pixel electrodes 150.

The counter electrode 170, which is disposed on the display area DA, may be disposed on an entire surface of the display area DA. For example, the counter electrode 170 may be integrally formed to cover the pixels. The counter electrode 170 may electrically contact a common power supply line arranged in the peripheral area PA. In an embodiment, the counter electrode 170 may extend to a blocking wall 200. A thin-film encapsulation layer TFE may cover an entire portion of the display area DA, and may be arranged to extend to the peripheral area PA and cover at least a portion of the peripheral area PA.

The thin-film encapsulation layer TFE may extend to outside of the common power supply line. The thin-film encapsulation layer TFE may include a first inorganic encapsulation layer 310, a second inorganic encapsulation layer 330, and an organic encapsulation layer 320 disposed between the first inorganic encapsulation layer 310 and the second inorganic encapsulation layer 330. The first inorganic encapsulation layer 310 and the second inorganic encapsulation layer 330 may include one or more inorganic materials from among aluminum oxide, titanium oxide, tantalum oxide, hafnium oxide, zinc oxide, silicon oxide, silicon nitride, and silicon oxynitride.

The first inorganic encapsulation layer 310 and the second inorganic encapsulation layer 330 may each include a single layer or multiple layers including the aforementioned materials. The first inorganic encapsulation layer 310 and the second inorganic encapsulation layer 330 may include same materials or different materials. The first inorganic encapsulation layer 310 and the second inorganic encapsulation layer 330 may have different thicknesses. The thickness of the first inorganic encapsulation layer 310 may be greater than the thickness of the second inorganic encapsulation layer 330. In another example, the thickness of the second inorganic encapsulation layer 330 may be greater than the thickness of the first inorganic encapsulation layer 310, or the thicknesses of the first inorganic encapsulation layer 310 and the second inorganic encapsulation layer 330 may be substantially identical to each other.

The organic encapsulation layer 320 may include a monomer-based material or a polymer-based material. The polymer-based material include an acryl-based resin, an epoxy-based resin, polyimide, polyethylene, and the like. In an embodiment, the organic encapsulation layer 320 may include an acrylate.

The blocking wall 200 may be disposed on the peripheral area PA of the substrate 100. In an embodiment, the blocking wall 200 may include a portion of the first organic insulating layer 104, a portion 230 of the second organic insulating layer 105, a portion 220 of the pixel defining layer 106, and a portion 210 of the spacer 80, but embodiments are not limited thereto.

In another example, the blocking wall 200 may only include the portion 230 of the second organic insulating layer 105 and the portion 220 of the pixel defining layer 106. The blocking wall 200 may be arranged to surround the display area DA, and may prevent the organic encapsulation layer 320 of the thin-film encapsulation layer TFE from overflowing outside the substrate 100. Accordingly, the organic encapsulation layer 320 may contact an inner surface of the blocking wall 200 facing the display area DA. For example, the description that the organic encapsulation layer 320 contacts the inner surface of the blocking wall 200 may be understood as the description that the first inorganic encapsulation layer 310 is between the organic encapsulation layer 320 and the blocking wall 200 and the organic encapsulation layer 320 contacts the first inorganic encapsulation layer 310.

The first inorganic encapsulation layer 310 and the second inorganic encapsulation layer 330 may be disposed on (or overlap) the blocking wall 200, and may extend toward edge portions of the substrate 100 to cover an upper surface and side surfaces of the blocking wall 200. In another example, the blocking wall 200 may be provided in plural.

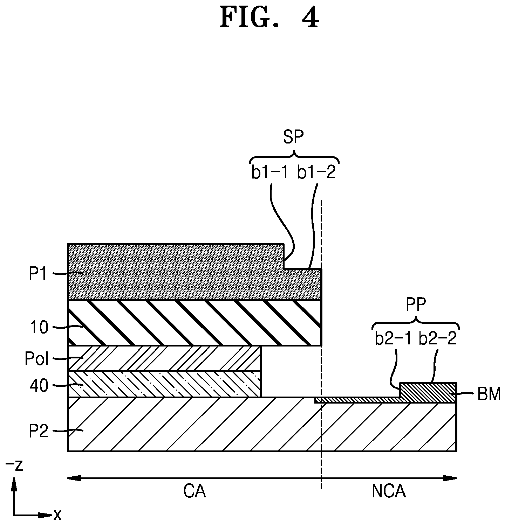

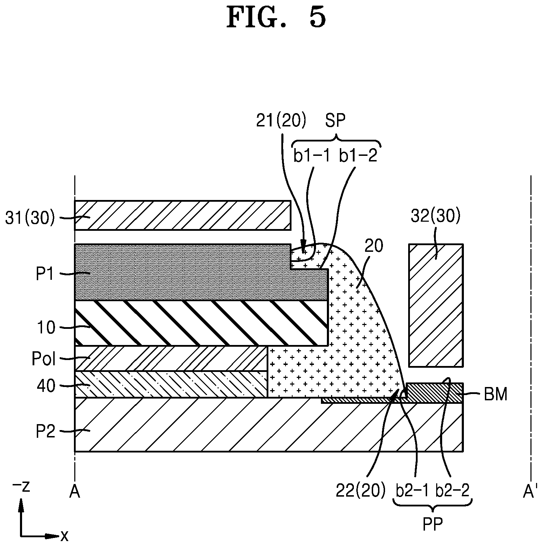

FIG. 4 is a schematic cross-sectional view schematically illustrating a portion of the display apparatus according to a first embodiment, and FIG. 5 also is a schematic cross-sectional view of a portion of the display apparatus according to the first embodiment.

From descriptions of the display apparatus with reference to FIGS. 4 and 5, same or repeated descriptions as the descriptions written above may be omitted for descriptive convenience.

In FIGS. 4 and 5, an upward direction may be a negative z-axis direction shown in the drawings, and a downward direction may be a positive z-axis shown in the drawings.

As shown in FIGS. 4 and 5, the display apparatus according to the first embodiment may include the display panel 10, a first cover plate P1, a second cover plate P2, and a side-surface covering member 20. For example, the display panel 10 may include the display panel 10 described with reference to FIGS. 1 to 3.

The first cover plate P1 may cover a top surface (or upper surface) of the display panel 10, and may include a step portion SP arranged in at least a portion of an edge portion of the first cover plate P1. The step portion SP may have a step shape in which a height of the step shape decreases from inside the first cover plate P1 toward outside the first cover plate P1.

The first cover plate P1 may prevent the permeation of foreign materials into the display panel 10, and may also protect the display panel 10 from external impacts. The first cover plate P1 may include transparent glass, plastic, or metal materials. For example, in case that light generated from the display panel 10 is emitted in the downward direction (e.g., the positive z-axis direction), the first cover plate P1 may include metal materials such as Ag and Al to reflect the light.

The first cover plate P1 may include the display area DA and the peripheral area PA described above. The display area DA of the first cover plate P1 may include an area corresponding to the display area DA of the display panel 10, and the peripheral area PA of the first cover plate P1 may correspond to the peripheral area PA of the display panel 10.

As shown in FIGS. 4 and 5, the step portion SP may include an inner surface b1-1 and a bottom surface (or lower surface) b1-2. The inner surface b1-1 of the step portion SP may extend in a substantially vertical direction with respect to a top surface (or upper surface) of the first cover plate P1. In plan view, or when viewed in a direction perpendicular to the substrate 100, the inner surface b1-1 of the step portion SP may be arranged inside a side surface of the display panel 10.

For example, a side closer to a center portion of the display panel 10 may be defined as inside, and a side closer to an edge portion or the side surface of the display panel 10 may be defined as outside. For example, in plan view, or when viewed in the direction perpendicular to the substrate 100, it may also be described that the inner surface b1-1 of the step portion SP is arranged further inward than the side surface of the display panel 10, and the side surface of the display panel 10 is arranged further outward than the inner surface b1-1 of the step portion SP. For example, in plan view, or when viewed in the direction perpendicular to the display panel 10, the inner surface b1-1 of the step portion SP may be arranged in an overlap area CA.

The bottom surface (or lower surface) b1-2 of the step portion SP may extend in a direction substantially perpendicular to the inner surface b1-1 of the step portion SP. The bottom surface (or lower surface) b1-2 of the step portion SP may extend in a direction substantially parallel to the top surface (or upper surface) of the first cover plate P1. However, this is only an example, and in another example, the inner surface b1-1 and the bottom surface (or lower surface) b1-2 of the step portion SP may together form a curve and thus may not be physically distinguished from each other.

In plan view, or when viewed in the direction perpendicular to the substrate 100, the bottom surface (or lower surface) b1-2 of the step portion SP may be arranged in the overlap area CA to be described later. In plan view, or when viewed in the direction perpendicular to the substrate 100, it may be described that the bottom surface (or lower surface) b1-2 of the step portion SP is arranged inside the side surface of the display panel 10 and the side surface of the display panel 10 is arranged outside the bottom surface (or lower surface) b1-2 of the step portion SP.

The second cover plate P2 may cover a bottom surface (or lower surface) of the display panel 10. The second cover plate P2 may include a transparent material. For example, the second cover plate P2 may include ultra-thin glass (UTG) as a glass layer. The second cover plate P2 may prevent the permeation of foreign materials into the display panel 10, and may also protect the display panel 10 from external impacts. For example, in case that light generated from the display panel 10 is emitted in the downward direction (e.g., the positive z-axis direction), the second cover plate P2 may be formed of transparent glass such as UTG to transmit the light.

In plan view, or when viewed in the direction perpendicular to the display panel 10, the second cover plate P2 and the first cover plate P1 may have the overlap area CA in which the second cover plate P2 and the first cover plate P1 partially overlap each other. In plan view, or when viewed in the direction perpendicular to the display panel 10, the second cover plate P2 and the first cover plate P1 may have a non-overlap area NCA in which the second cover plate P2 and the first cover plate P1 do not partially overlap each other. For example, in plan view or when viewed in the direction perpendicular to the display panel 10, an area (or size) of the first cover plate P1 may be less than an area (or size) of the second cover plate P2.

A protrusion portion PP may be disposed on the second cover plate P2. In plan view or when viewed in the direction perpendicular to the display panel 10, the protrusion portion PP may be disposed in an area of the top surface (or upper surface) of the second cover plate P2, which does not overlap the first cover plate P1. In plan view or when viewed in the direction perpendicular to the display panel 10, the protrusion portion PP may be spaced apart from an edge portion of the first cover plate P1 by a certain distance.

The side-surface covering member 20 may at least partially cover a portion of the side surface of the display panel 10, which is exposed between the step portion SP and the protrusion portion PP. The side-surface covering member 20 may at least partially cover a portion of the side surface of the display panel 10 exposed between the first cover plate P1 and the second cover plate P2. For example, the side-surface covering member 20 may be defined as a configuration (e.g., structure or layer) to cover the side surface of the display panel 10 between the inner surface b1-1 of the step portion SP and an outer surface b2-1 of the protrusion portion PP. As a result, the side-surface covering member 20 may cover or contact at least a portion of the inner surface b1-1 of the step portion SP, the bottom surface (or lower surface) b1-2 of the step portion SP, a portion of a top surface (or upper surface) of the second cover plate P2, and at least a portion of the outer surface b2-1 of the protrusion portion PP.

The side-surface covering member 20 may include a conductive ink composition. For example, the conductive ink composition may include nanoparticles of one or more metals selected from among a group including Ag, Au, Cu, Ni, Pd, Pt, and alloys thereof. Furthermore, for example to the nanoparticles of the one or more metals, the conductive ink composition may further include a resin. In case that the side-surface covering member 20 includes the conductive ink composition, the display panel 10 may be protected from static electricity caused due to touch of a user. The conductive ink composition included in the side-surface covering member 20 may be in a liquid state under a room temperature. As a result, in a coating process, the conductive ink composition may be coated at a certain position or near the certain position. For example, a method of forming the side-surface covering member on the side surface of the display panel 10 may include a liquid application method.

The conductive ink composition included in the side-surface covering member 20 may include a UV-curable material. Curing conditions of the UV-curable material may include (1) UV dose ≤ 6 (J/cm²) and (2) a thickness less than 300 µm. For example, the conductive ink composition may have a thixotropic index of about 2.0 to about 2.6, a sheet resistance of about 10⁵ (Ω/sq) or less, and a shear modulus of about 1 (GPa) or less.

In another example, the side-surface covering member 20 may have a sealing material such as a resin or a corner sealant. In case that the side-surface covering member 20 including the sealing material is used, the intensity (or strength) between the first cover plate P1 and the second cover plate P2, which resist against panel resistance, external impacts, and the like, may be enhanced. The sealing material such as a corner sealant, which is included in the side-surface covering member 20, may be in a liquid state under a room temperature. As a result, in an application, the conductive ink composition may be applied at a certain position or near the certain position. For example, a method of forming the side-surface covering member 20 on the side surface of the display panel 10 may include a liquid application method.

The sealing material such as a corner sealant, which is included in the side-surface covering member 20, may include a UV-curable material. Curing conditions of the UV-curable material may include (1) UV dose ≤6 (J/cm²) and (2) a thickness less than 400 µm. For example, the sealing material may have a shear modulus of about 10 (MPa) or greater, a tensile strength of about 600 (N/cm²) or greater, and a shear strength of about 500 (N/cm²) or greater.

As a result, the side-surface covering member 20 may be applied (or formed) on at least a portion of the inner surface b1-1 of the step portion SP, a bottom surface (or lower surface) b1-2 of the step portion SP, at least a portion of the top surface (or upper surface) of the second cover plate P2, and at least a portion of the outer surface b2-1 of the protrusion portion.

For example, an application area (or covering area) in which the side-surface covering member 20 is applied (or formed) on another component may be an area between the inner surface b1-1 of the step portion SP and the outer surface b2-1 of the protrusion portion PP, and therefore, the application area of the side-surface covering member 20 may be partially defined by the inner surface b1-1 of the step portion SP and the outer surface b2-1 of the protrusion portion PP.

For example, the side-surface covering member 20 may further cover at least a portion of the inner surface b1-1 of the step portion SP and the bottom surface (or lower surface) b1-2 of the step portion SP. In another example, the side-surface covering member 20 may cover at least a portion of the outer surface b2-1 of the protrusion portion PP. For example, the side-surface covering member 20 may further cover a portion of the top surface (or upper surface) of the second cover plate P2, which is exposed between the display panel 10 and the protrusion portion PP.

An edge portion 21 of the side-surface covering member 20 may contact at least a portion of the inner surface b1-1 of the step portion SP and may have a shape corresponding to a shape of the inner surface b1-1 of the step portion SP. For example, the edge portion 21 of the side-surface covering member 20 may be an end portion of the side-surface covering member 20 contacting the step portion SP or arranged around the step portion SP. The edge portion 21 of the side-surface covering member 20 may be applied (or formed) on the step portion SP and thus may have a shape corresponding to a shape of the step portion SP.

For example, in case that the inner surface b1-1 of the step portion SP is planar, a surface of the edge portion 21 contacting the inner surface b1-1 of the step portion SP may also be planar. For example, in case that the inner surface b1-1 of the step portion SP is curved, a surface of the edge portion 21 contacting the inner surface b1-1 of the step portion SP may also be curved.

As shown in FIGS. 4 and 5, the protrusion portion PP may protrude with respect to the top surface (or upper surface) of the second cover plate P2. For example, the protrusion portion PP may be arranged on a top surface (or upper surface) of the second cover plate P2 in the non-overlap area NCA, and may protrude in a vertical direction from the top surface (or upper surface) of the second cover plate P2. In plan view or when viewed in the direction perpendicular to the display panel 10, the protrusion portion PP may not overlap the first cover plate P1.

A light-blocking material layer BM may be disposed on the top surface (or upper surface) of the second cover plate P2. To prevent leakage of light of the display panel 10 through the non-overlap area NCA, or to provide aesthetic effect in case that the display panel 10 is viewed from outside, the light-blocking material layer BM may be disposed on the top surface (or upper surface) of the second cover plate P2 in the non-overlap area NCA.

In another example, the protrusion portion PP may include a light-blocking material. In another example, the protrusion portion PP may include a portion of the light-blocking material layer BM, and may protrude in the vertical direction with respect to the light-blocking material layer BM, as well as with respect to the top surface (or upper surface) of the second cover plate P2.

As shown in FIGS. 4 and 5, the protrusion portion PP may include the outer surface b2-1 and a top surface (or upper surface). The outer surface b2-1 of the protrusion portion PP may extend in a direction substantially vertical to the top surface (or upper surface) of the second cover plate P2. In plan view or when viewed in the direction perpendicular to the substrate 100, the outer surface b2-1 of the protrusion portion PP may be arranged outside the side surface of the display panel 10.

For example, in plan view or when viewed in the direction perpendicular to the substrate, it may be described that the outer surface b2-1 of the step portion SP is arranged outside the side surface of the display panel 10 and the side surface of the display panel 10 is arranged inside the outer surface b2-1 of the protrusion portion PP. For example, in plan view or when viewed in the direction perpendicular to the substrate 100, the outer surface b2-1 of the protrusion portion PP may be arranged in the non-overlap area NCA.

The top surface (or upper surface) b2-2 of the protrusion portion PP may extend in a direction substantially perpendicular to the inner surface b1-1 of the step portion SP. The top surface (or upper surface) b2-2 of the protrusion portion PP may extend in a direction substantially parallel to the top surface (or upper surface) of the second cover plate P2. However, this is only an example, and in another example, the outer surface b2-1 and the top surface (or upper surface) b2-2 of the protrusion portion PP may together form a curve and thus may not be physically distinguished from each other.

In plan view or when viewed in the direction perpendicular to the substrate 100, the top surface (or upper surface) b2-2 of the protrusion portion PP may be arranged in the non-overlap area NCA. In plan view or when viewed in the direction perpendicular to the substrate 100, it may be described that the top surface (or upper surface) b2-2 of the protrusion portion PP is arranged outside the side surface of the display panel 10 and the side surface of the display panel 10 is arranged inside the top surface (or upper surface) b2-2 of the protrusion portion PP.

Another edge portion 22 of the side-surface covering member 20 may contact at least a portion of the outer surface b2-1 of the protrusion portion PP, and may have a shape corresponding to a shape of the outer surface b2-1 of the protrusion portion PP. For example, the other edge portion 22 of the side-surface covering member 20 may be an end portion of the side-surface covering member 20 contacting the protrusion portion PP or arranged near the protrusion portion PP. The other edge portion 22 of the side-surface covering member 20 may be applied (or formed) on at least a portion of the outer surface b2-1 of the protrusion portion PP, and may have a shape corresponding to a shape of the outer surface b2-1 of the protrusion portion PP.

For example, in case that the outer surface b2-1 of the protrusion portion PP is planar, a surface of the other edge portion 22 contacting the outer surface b2-1 of the protrusion portion PP may also be planar. For example, in case that the outer surface b2-1 of the protrusion portion PP is curved, a surface of the other edge portion 22 contacting the outer surface b2-1 of the protrusion portion PP may also be curved.

As shown in FIGS. 4 and 5, the display apparatus according to the first embodiment may further include a polarization layer Pol. The polarization layer Pol may be disposed under the display panel 10. The polarization layer Pol may be disposed between the display panel 10 and the second cover plate P2.

From the light emitted from the display panel 10, the polarization layer Pol may only transmit light vibrating in a direction identical to a vibration direction of a polarization axis, but may absorb or reflect light vibrating in other directions. The polarization layer Pol may include a phase-difference layer and a polarization layer. The phase-difference layer may provide a phase difference of λ/4 to two polarization components perpendicular to each other to convert linear polarization into circular polarization or convert circular polarization into linear polarization. The polarization layer may align a direction of the light transmitted through the phase-difference layer, may divide the light into two polarization components orthogonal to each other, and may transmit only one of the components and aborb or scatter another one of the components. In another example, the polarization layer Pol may be omitted.

In plan view or when viewed in the direction perpendicular to the display panel 10, an area (or size) of the polarization layer Pol may be less than an area (or size) of the first cover plate P1. In plan view or when viewed in the direction perpendicular to the display panel 10, the area (or size) of the polarization layer Pol may be less than an area (or size) of the display panel 10. In plan view or when viewed in the direction perpendicular to the display panel 10, the area (or size) of the polarization layer Pol may be less than an area (or size) of the second cover plate P2.

As shown in FIGS. 4 and 5, the display apparatus according to the first embodiment may further include an adhesive layer 40. The adhesive layer 40 may be disposed under the display panel 10, and may be disposed between the display panel 10 and the second cover plate P2. For example, the adhesive layer 40 may be disposed under the polarization layer Pol, and may be disposed between the polarization layer Pol and the second cover plate P2. The adhesive layer 40 may include at least one of an optical clear adhesive (OCA), a pressure-sensitive adhesive (PSA), a thermal responsive adhesive, a general adhesive, or a double-sided tape.

In plan view or when viewed in the direction perpendicular to the display panel 10, an area (or size) of the adhesive layer 40 may be less than the area (or size) of the first cover plate P1. In plan view or when viewed in the direction perpendicular to the display panel 10, an area (or size) of the adhesive layer 40 may be less than the area (or size) of the display panel 10. In plan view or when viewed in the direction perpendicular to the display panel, the area (or size) of the adhesive layer 40 may be less than the area (or size) of the second cover plate P2.

As shown in FIG. 5, the display apparatus may further include a fastening member 30 contacting the first cover plate P1 and/or the second cover plate P2 or being fastened thereto. In case of contacting or being fastened to the first cover plate P1 and/or the second cover plate P2, the fastening member 30 may not be interfered by the side-surface covering member 20. For example, in case that the fastening member 30 contacts or is fastened to the first cover plate P1 and/or the second cover plate P2, the fastening member 30 may be spaced apart from the side-surface covering member 20 without contact.

For example, in case that the fastening member 30 is fastened, the side-surface covering member 20 may be spaced apart from the fastening member 30 due to the step portion SP. As the application area of the side-surface covering member 20 is limited by the inner surface b1-1 of the step portion SP, the side-surface covering member 20 may not cover the top surface (or upper surface) of the first cover plate P1. As a result, the fastening member 30 contacting or being fastened to the top surface (or upper surface) of the first cover plate P1 may not be interfered by the side-surface covering member 20.

For example, in case that the fastening member 30 is fastened, the side-surface covering member 20 may be spaced apart from the fastening member 30 by the protrusion portion PP. As the application area of the side-surface covering member 20 is limited by the outer surface b2-1 of the protrusion portion PP, the side-surface covering member 20 may not cover an area outside the protrusion portion PP or the top surface (or upper surface) b2-2 of the protrusion portion PP in the top surface (or upper surface) of the second cover plate P2. As a result, the fastening member 30 contacting or being fastened to the top surface (or upper surface) of the second cover plate P2 may not be interfered by the side-surface covering member 20.

The fastening member 30 may include a first fastening portion 31 contacting or being fastened to the first cover plate P1 and a second fastening portion 32 contacting or being fastened to the second cover plate P2. The first fastening portion 31 may contact the top surface (or upper surface) of the first cover plate P1, and the second fastening portion 32 may contact the top surface (or upper surface) b2-2 of the protrusion portion PP.

The first fastening portion 31 and the second fastening portion 32 shown in FIG. 5 are only illustrated as parts of the fastening member 30, and this is only an example for understanding of the invention. For example, the fastening member 30 may further include configurations other than the first fastening portion 31 and the second fastening portion 32, and In another example, one of the first fastening portion 31 and the second fastening portion 32 may be omitted.

For example, the fastening member 30 may include an outer housing of the display apparatus, and the first fastening portion 31 and the second fastening portion 32 may include parts of the fastening member 30 to fasten the first cover plate P1, the second cover plate P2, and the outer housing.

As shown in FIG. 5, the light-blocking material layer BM may be disposed on the second cover plate P2. The light-blocking material layer BM may be arranged in the non-overlap area NCA. The light-blocking material layer BM, which is a black matrix, may include various materials capable of absorbing at least a portion of the light. For example, the light-blocking material layer BM may include at least one of carbon black, graphite, a chromium-based material, dyes, a metal-based reflective layer, and a light-absorbing layer. The light-blocking material layer BM, which is disposed on the second cover plate P2 in the non-overlap area NCA, may form an edge portion of the display apparatus that is viewed as black when the display apparatus is viewed from outside.

The protrusion portion PP may be included in (or disposed on) the light-blocking material layer BM, and may protrude to form a top surface (or upper surface) of the light-blocking material layer BM. In another example, the protrusion portion PP may include a light-blocking material identical to the light-blocking material of the light-blocking material layer BM. For example, as a portion of the light-blocking material layer BM, the protrusion portion PP may also be simultaneously formed with the light-blocking material layer BM.

As shown in FIGS. 4 and 5, a height of the inner surface b1-1 of the step portion SP may be about 0.02 mm or greater but not more than about 0.05 mm. The height of the inner surface b1-1 of the step portion SP may be determined to ensure a minimum thickness and sufficient peel strength for conduction, and may be about 0.02 mm or greater but not more than about 0.05 mm in order to ensure a minimum height for limiting the application area (or covering area) in which the side-surface covering member 20 is coated. A height of the first cover plate P1 including the step portion SP may be about about 0.07 mm or greater.

A height of the protrusion portion PP or the height of the outer surface b2-1 of the protrusion portion PP may be about 0.02 mm or greater but not more than about 0.05 mm. The height of the protrusion portion PP or the height of the outer surface b2-1 of the protrusion portion PP may be determined in order to minimize the possibility of interference with the display panel 10 as well as to ensure the minimum height for limiting the application area of the side-surface covering member 20.

A width of the bottom surface (or lower surface) b1-2 of the step portion SP may be about 0.1 mm or greater but not more than about 0.5 mm. The width of the bottom surface (or lower surface) b1-2 of the step portion SP may be determined in order to ensure a minimum width and sufficient peel strength for conduction as well as to minimize interference with the fastening member 30.

A width of the top surface (or upper surface) b2-2 of the protrusion portion PP may be about 0.3 mm or greater but not more than about 1.2 mm. The width of the top surface (or upper surface) b2-2 of the protrusion portion PP may be determined in order to form a slim bezel as well as to ensure stable fastening of the fastening member 30.

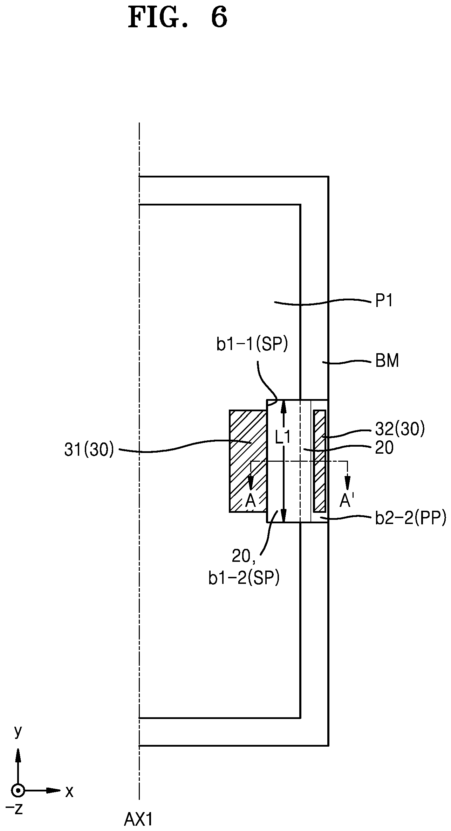

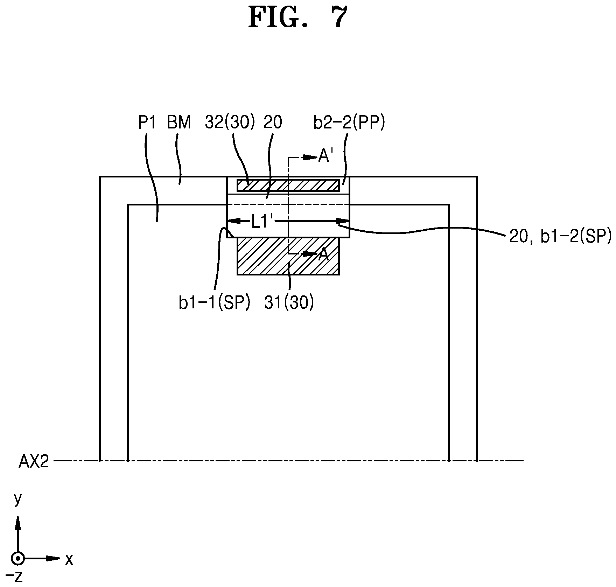

FIG. 6 is a schematic plan view schematically illustrating an example in which a structure shown in the schematic cross-sectional view of FIG. 5 is applicable to the display panel partially illustrated with reference to the first axis AX1. FIG. 7 is a schematic plan view schematically illustrating another example in which the structure in the schematic cross-sectional view of FIG. 5 is applicable to the display panel partially illustrated with reference to the second axis AX2.

From descriptions with reference to FIGS. 6 and 7, same or repeated descriptions as the descriptions written above may be omitted for descriptive convenience. For example, a cross-section taken along line A-A' shown in FIG. 5 may have the structure shown in FIG. 5, and a cross-section taken along line A-A' shown in FIG. 7 may also have the structure shown in FIG. 5.

As shown in FIG. 6, the first fastening portion 31 and the second fastening portion 32 may not be interfered by the side-surface covering member 20 in case that of the first and second fastening portions 31 and 32 are fastened. The side-surface covering member 20 may cover the bottom surface (or lower surface) b1-2 of the step portion SP, and may be applied (or formed) to have a first width L1. The first width L1 may include a width of the side-surface covering member 20 measured along a y-axis in plan view. For example, the first width L1 may be substantially identical or similar to a width of the bottom surface (or lower surface) b1-2 of the step portion SP measured along the y-axis in plan view.

For example, the first width L1 may be about 3 mm or greater but not greater than a length of a side of the display panel 10 on which the side-surface covering member 20 is applied (or formed). In case that the first width L1 is less than about 3 mm, the first fastening portion 31 and the second fastening portion 32 may not be firmly fastened to the display panel 10. In case that the first width L1 is greater than the length of the side of the display panel 10, it is required that the first fastening portion 31 and the second fastening portion 32 are designed to be greater than the display panel 10, which causes unnecessary consumption of space and materials.

The side-surface covering member 20 may be coated to have a width identical or similar to the width along the y-axis of the bottom surface (or lower surface) b1-2 of the step portion SP in plan view. In another example, there may be differences caused due to errors in an application process. In other areas (e.g., upper and lower edge portions of the display apparatus in the y-axis direction), the light-blocking material layer BM may be viewed in plan view, and the side-surface covering member 20 may be coated mainly in areas (e.g., center edge portion of the display apparatus in the y-axis direction), corresponding to the first fastening portion 31 and the second fastening portion 32.

Although an example of a portion of the display panel 10 is shown with reference to the first axis AX1, the structure shown in the schematic cross-sectional view of FIG. 5 may also be applicable to other omitted portions. For example, in case that the display panel 10 has a square shape including four sides, the structure shown in the schematic cross-sectional view of FIG. 5 may be applicable only to a side with reference to the first axis AX1. For example, in case that the display panel 10 has a square shape including four sides, the structure shown in the schematic cross-sectional view of FIG. 5 may be applicable to two sides with reference to the first axis AX1. For example, in case that the display panel 10 has a square shape including four sides, the structure shown in the schematic cross-sectional view of FIG. 5 may be applicable to all of the four sides.

As shown in FIG. 7, the first fastening portion 31 and the second fastening portion 32 may not be interfered by the side-surface covering member 20 in case that the first and second fastening portions 31 and 32 are fastened. The side-surface covering member 20 may cover the bottom surface (or lower surface) b1-2 of the step portion SP and may be formed to have a first width L1'. The first width L1' may include a width of the side-surface covering member 20 measured along the x-axis in plan view. For example, the first width L1' may be substantially identical or similar to the width of the bottom surface (or lower surface) b1-2 of the step portion SP measured along the x-axis in plan view.

For example, the first width L1' may be about 3 mm or greater but not greater than the length of the side of the display panel 10 on which the side-surface covering member 20 is applied (or formed). In case that the first width L1' is less than about 3 mm, the first fastening portion 31 and the second fastening portion 32 may not be firmly fastened to the display panel 10. In case that the first width L1' is greater than the length of the side of the display panel 10, it is required that the first fastening portion 31 and the second fastening portion 32 are designed to be greater than the display panel 10, which causes unnecessary consumption of space and materials.

The side-surface covering member 20 may be formed to have a width identical or similar to the width along the x-axis of the bottom surface (or lower surface) b1-2 of the step portion SP in plan view. In another example, there may be differences caused due to errors in the application process. In other areas (e.g., left and right edge portions of the display apparatus in the x-axis direction), the light-blocking material layer BM may be viewed in plan view, and the side-surface covering member 20 may be applied (or formed) mainly in areas

(e.g., center portion of the display apparatus in the x-axis direction) corresponding to the first fastening portion 31 and the second fastening portion 32.

Although an example of a portion of the display panel 10 with reference to a second axis AX2 is shown, the structure shown in the schematic cross-sectional view of FIG. 5 may also be applicable to other emitted portions. For example, in case that the display panel 10 has a square shape including four sides, the structure shown in the schematic cross-sectional view of FIG. 5 may be applicable only to a side with reference to the second axis AX2. For example, in case that the display panel 10 has a square shape including four sides, the structure shown in the schematic cross-sectional view of FIG. 5 may be applicable to two sides with reference to the second axis AX2. For example, in case that the display panel 10 has a square shape including four sides, the structure shown in the schematic cross-sectional view of FIG. 5 may be applicable to all of the four sides.

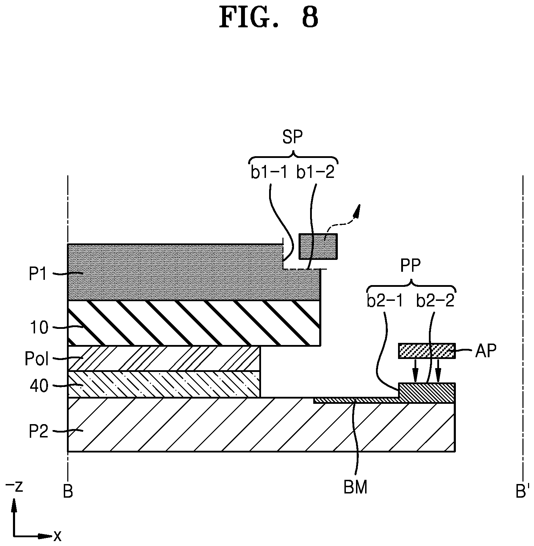

FIG. 8 is a cross-sectional view schematically illustrating some operations of a method of manufacturing the display apparatus according to the first embodiment. From the descriptions of the display apparatus with reference to FIG. 8, same or repeated descriptions as the descriptions written above may be omitted for descriptive convenience.

As shown in FIG. 8, a portion of the edge portion of the first cover plate P1 may be removed by a laser process and the like. As the portion of the edge portion of the first cover plate P1 is removed, the step portion SP may be formed at the edge portion of the first cover plate P1. The step portion SP formed at the edge portion of the first cover plate P1 may be formed into a step shape in a direction from inside the first cover plate P1 toward outside the first cover plate P1. For example, the step portion SP may have a step shape in which a height of the step shape decreases toward outside the first cover plate P1.

For example, the method of manufacturing the display apparatus (hereinafter, the manufacturing method) may be as follows.

The manufacturing method may include attaching the first cover plate P1 to the top surface (or upper surface) of the display panel 10, attaching the second cover plate P2 on the bottom surface (or lower surface) of the display panel 10 using the adhesive layer 40, and forming the step portion SP by removing a portion of the edge portion of the first cover plate P1. In another example, the manufacturing method may further include forming the polarization layer Pol between the display panel 10 and the adhesive layer 40.

The forming of the step portion SP by removing the portion of the edge portion of the first cover plate P1 may include forming the step portion SP by applying a laser process and the like at a certain position of the edge portion of the first cover plate P1.

The manufacturing method may further include forming the protrusion portion PP on the top surface (or upper surface) of the second cover plate P2. For example, in plan view or when viewed in the direction perpendicular to the display panel 10, the protrusion portion PP may be arranged in an area in which the first cover plate P1 and the second cover plate P2 do not overlap each other.

The forming of the protrusion portion PP on the top surface (or upper surface) of the second cover plate P2 may include forming the protrusion portion PP including a material identical to the material of the light-blocking material layer BM and protruding with respect to the top surface (or upper surface) of the light-blocking material layer BM. In another example, the forming of the protrusion portion PP on the top surface (or upper surface) of the second cover plate P2 may include attaching an additional curing member AP or curing after the attaching of the additional curing member AP to the top surface (or upper surface) of the light-blocking material layer BM.

The attaching of the additional curing member AP or the curing after the attaching of the additional curing member AP may be performed on the top surface (or upper surface) b2-2 of the protrusion portion PP. The additional curing member AP may be used in case that the height of the protrusion portion PP including the material identical to the material of the light-blocking material layer BM is insufficient.

In another example, the additional curing member AP may be adhered (e.g., directly adhered) to the top surface (or upper surface) of the light-blocking material layer BM or may be cured after adhesion. For example, the additional curing member AP may correspond to the protrusion portion PP, or may function as the protrusion portion PP.

The manufacturing method may further include forming the side-surface covering member 20 by applying a strength-enhancing material in a portion of the side surface of the display panel 10, which is exposed between the step portion SP and the protrusion portion PP. For example, an application area (or covering area) of the side-surface covering member 20 with respect to the top surface (or upper surface) of the first cover plate P1 may be limited by the step portion SP. The application area of the side-surface covering member 20 with respect to the top surface (or upper surface) of the second cover plate P2 may be limited by the protrusion portion PP.

The manufacturing method may further include fastening the first cover plate P1 and the second cover plate P2 by the fastening member 30 without (e.g., configured to avoid) interference with the side-surface covering member 20.

The step portion SP may limit or define the application area of the side-surface covering member 20 such that the side-surface covering member 20 may not exceed a certain range of the top surface (or upper surface) of the first cover plate P1 in case that the side-surface covering member 20 is formed or applied.

The application area of the side-surface covering member 20 may be limited or defined by the step portion SP in case that the side-surface covering member 20 is applied or formed. Thus, a shape of the edge portion 21 of the side-surface covering member 20 may correspond to a shape of the inner surface b1-1 of the step portion SP. For example, the edge portion 21 of the side-surface covering member 20 may be disposed on the top surface (or upper surface) of the first cover plate P1. As the shape of the edge portion 21 of the side-surface covering member 20 corresponds to the shape of the inner surface b1-1 of the step portion SP, the edge portion 21 of the side-surface covering member 20 may have step portions with respect to the top surface (or upper surface) of the first cover plate P1.

The protrusion portion PP may limit or define the application area of the side-surface covering member 20 such that the side-surface covering member 20 may not exceed a certain range of the top surface (or upper surface) of the second cover plate P2 in case that the side-surface covering member 20 is formed or applied.

The application area of the side-surface covering member 20 may be limited or defined by the protrusion portion PP in case that the side-surface covering member 20 is applied or formed. Thus, a shape of the other edge portion 22 of the side-surface covering member 20 may correspond to a shape of the outer surface b2-1 of the protrusion portion PP. For example, the other edge portion 22 of the side-surface covering member 20 may be disposed on the top surface (or upper surface) of the second cover plate P2, and may be arranged in the non-overlap area NCA. As the shape of the other edge portion 22 of the side-surface covering member 20 corresponds to the shape of the outer surface b2-1 of the protrusion portion PP, the other edge portion 22 of the side-surface covering member 20 may have step portions with respect to the top surface (or upper surface) of the second cover plate P2 or the top surface (or upper surface) of the light-blocking material layer BM. In another example, the light-blocking material layer BM may be disposed between the other edge portion 22 of the side-surface covering member 20 and the top surface (or upper surface) of the second cover plate P2, and the other edge portion 22 of the side-surface covering member 20 may be disposed on the light-blocking material layer BM.

For example, the side-surface covering member 20 may cover a portion of the top surface (or upper surface) of the second cover plate P2, and the other edge portion 22 of the side-surface covering member 20 may have step portions with respect to the top surface (or upper surface) of the second cover plate P2.

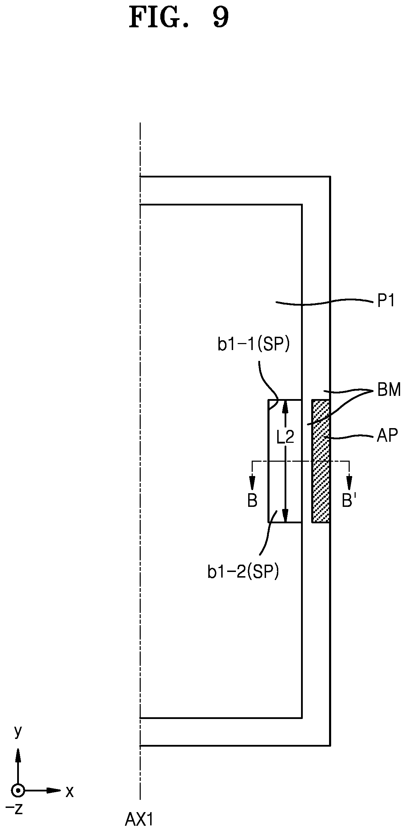

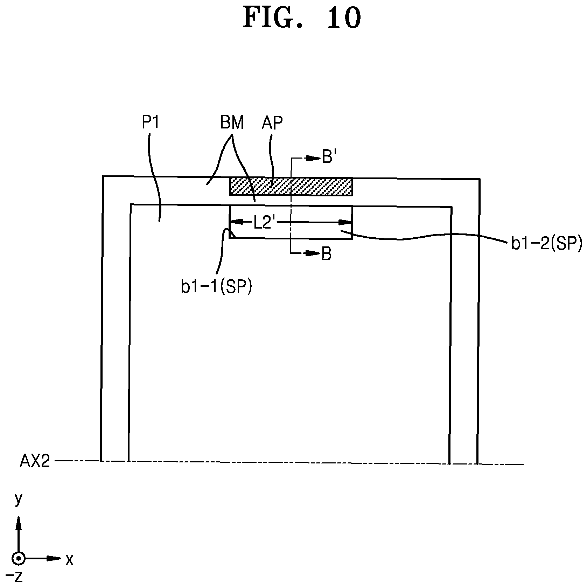

FIG. 9 is a schematic plan view schematically illustrating an example in which a structure shown in the schematic cross-sectional view of FIG. 8 is applicable to the display panel partially illustrated with reference to the first axis AX1 shown in FIG. 1, and FIG. 10 is a schematic plan view schematically illustrating another example in which the structure shown in the schematic cross-sectional view of FIG. 8 is applicable to the display panel partially illustrated with reference to the second axis AX2 shown in FIG. 8.

From descriptions with reference to FIGS. 9 and 10, same or repeated descriptions as the descriptions written above may be omitted for descriptive convenience. For example, a cross-section taken along line B-B' shown in FIG. 9 may have the structure shown in FIG. 8, and a cross-section taken along line B-B' shown in FIG. 10 may also have the structure shown in FIG. 8.

As shown in FIG. 9, after a portion of the edge portion of the first cover plate P1 is removed by a laser process and the like, the bottom surface (or lower surface) b1-2 of the step portion SP is viewed in plan view. Like in FIG. 8, the side-surface covering member 20 is omitted for convenience of explanation.

Although an example of a portion of the display panel 10 is shown with reference to the first axis AX1, the structure of the schematic cross-sectional view shown in FIG. 8 may also be applicable to other omitted portions. For example, in case that the display panel 10 has a square shape including four sides, the structure shown in the schematic cross-sectional view of FIG. 8 may be applicable to only one side with reference to the first axis AX1. For example, in case that the display panel 10 has a square shape including four sides, the structure shown in the cross-sectional view of FIG. 8 may be applicable to two sides with reference to the first axis AX1. For example, in case that the display panel 10 has a square shape including four sides, the structure shown in the schematic cross-sectional view of FIG. 8 may be applicable to all of the four sides.

Although the side-surface covering member 20 is omitted for convenience of explanation, the side-surface covering member 20 may cover the bottom surface (or lower surface) b1-2 of the step portion SP and may be formed to have a second width L2. The second width L2 may include a width of the side-surface covering member 20 measured along the y-axis in plan view. For example, the second width L2 may be substantially identical or similar to the width of the bottom surface (or lower surface) b1-2 of the step portion SP measured along the y-axis in plan view. Application characteristics of the side-surface covering member 20 may be clearly understood based on the descriptions with reference to FIGS. 6 and 7.

For example, the second width L2 may be about 3 mm or greater but not greater than the length of the side of the display panel 10 on which the side-surface covering member 20 is applied (or formed). In case that the second width L2 is less than about 3 mm, the first fastening portion 31 and the second fastening portion 32 may not be firmly fastened to the display panel 10. In case that the second width L2 is greater than the length of the side of the display panel 10, it is required that the first fastening portion 31 and the second fastening portion 32 are designed to be greater than the display panel 10, which causes unnecessary consumption of space and materials.

The side-surface covering member 20 may be coated to have a width identical or similar to the width along the y-axis of the bottom surface (or lower surface) b1-2 of the step portion SP in plan view, and in another example, there may be differences caused due to errors in an application process. In other areas, the light-blocking material layer BM may be viewed in plan view. Although descriptions of the first fastening portion 31 and the second fastening portion 32 are omitted for convenience of explanation, descriptions of the first fastening portion 31 and the second fastening portion 32 may be clearly understood based on the descriptions with reference to FIGS. 6 and 7. In FIG. 9, the side-surface covering member 20 still may be applied (or formed) mainly in areas corresponding to the first fastening portion 31 and the second fastening portion 32.

As shown in FIG. 10, after a portion of the edge portion of the first cover plate P1 is removed by a laser process and the like, the bottom surface (or lower surface) b1-2 of the step portion SP is viewed in plan view. Like in FIG. 8, the side-surface covering member 20 is omitted for convenience of explanation.

Although an example of a portion of the display panel 10 is shown with reference to the second axis AX2, the structure of the schematic cross-sectional view shown in FIG. 8 may also be applicable to other omitted portions. For example, in case that the display panel 10 has a square shape including four sides, the structure shown in the schematic cross-sectional view of FIG. 8 may be applicable only to one side with reference to the second axis AX2. For example, in case that the display panel 10 has a square shape including four sides, the structure shown in the schematic cross-sectional view of FIG. 8 may be applicable two sides with reference to the second axis AX2. For example, in case that the display panel 10 has a square shape including four sides, the structure shown in the schematic cross-sectional view of FIG. 8 may be applicable to all of the four sides.

Although the side-surface covering member 20 is omitted for convenience of explanation, the side-surface covering member 20 may cover the bottom surface (or lower surface) b1-2 of the step portion SP and may be formed to have a second width L2'. The second width L2' may include a width of the side-surface covering member 20 measured along the x-axis in plan view. For example, the second width L2' may be substantially identical or similar to a width of the bottom surface (or lower surface) b1-2 of the step portion SP measured along the x-axis in plan view. Application characteristics of the side-surface covering member 20 may be clearly understood based on the descriptions with reference to FIGS. 6 and 7.

For example, the second width L2' may be about 3 mm or greater but not greater than the length of the side of the display panel 10 on which the side-surface covering member 20 is applied (or formed). In case that the second width L2' is less than about 3 mm, the first fastening portion 31 and the second fastening portion 32 may not be firmly fastened to the display panel 10. In case that the second width L2' is greater than a length of a side of the display panel 10, it is required that the first fastening portion 31 and the second fastening portion 32 are designed to be greater than the display panel 10, which causes unnecessary consumption of space and materials.

The side-surface covering member 20 may be formed to have a width identical or similar to the width along the x-axis of the bottom surface (or lower surface) b1-2 of the step portion SP in plan view. In another example, there may be differences caused due to errors in the application process. In other areas, the light-blocking material layer BM may be viewed in plan view. Although descriptions of the first fastening portion 31 and the second fastening portion 32 are omitted for convenience of explanation, descriptions of the first fastening portion 31 and the second fastening portion 32 may be clearly understood based on the descriptions with reference to FIGS. 6 and 7. In FIG. 10, the side-surface covering member 20 still may be applied (or formed) mainly in the areas corresponding to the first fastening portion 31 and the second fastening portion 32.

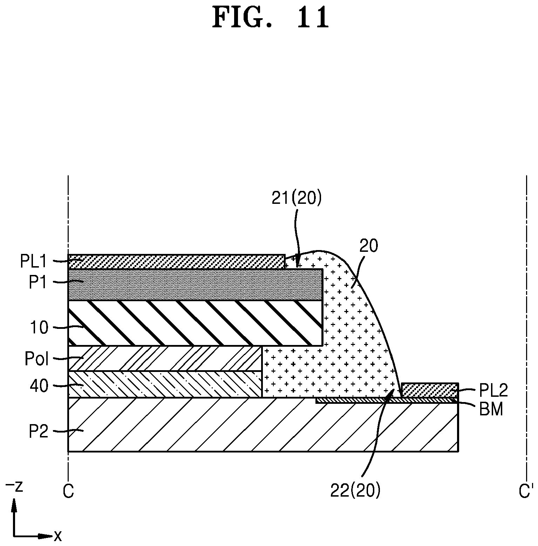

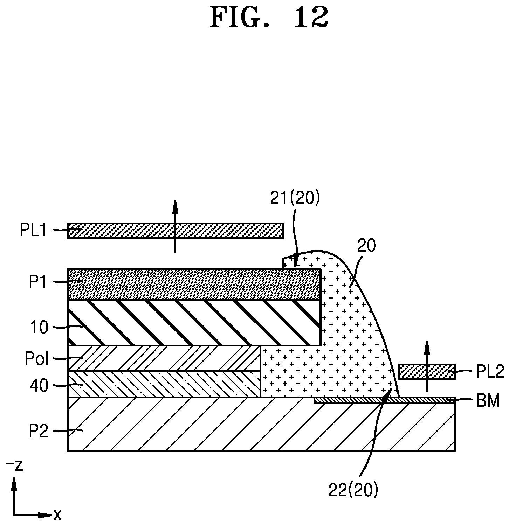

FIGS. 11 and 12 are cross-sectional views each schematically illustrating an operation of the method of manufacturing the display apparatus according to the second embodiment.

From descriptions of the display apparatus with reference to FIGS. 11 and 12, same or repeated descriptions as the descriptions written above may be omitted for descriptive convenience.

As shown in FIGS. 11 and 12, the manufacturing method of the display apparatus according to the second embodiment may include attaching the first cover plate P1 on the top surface (or upper surface) of the display panel 10, attaching the second cover plate P2 on the bottom surface (or lower surface) of the display panel 10 using the adhesive layer 40, forming the step portion SP with respect to the top surface (or upper surface) of the first cover plate P1 in a thickness identical to a thickness of a first protective layer PL1 by attaching the first protective layer PL1 on the top surface (or upper surface) of the first cover plate P1, forming the protrusion portion PP protruding with respect to the top surface (or upper surface) of the second cover plate P2 in a thickness identical to a thickness of a second protective layer PL2 by attaching the second protective layer PL2 to an area exposed upward in the top surface (or upper surface) of the second cover plate P2, forming the side-surface covering member 20 by applying a strength-enhancing material on a portion of the side surface of the display panel 10, which is exposed between the step portion SP and the protrusion portion PP, and removing the first protective layer PL1 or the second protective layer PL2 after the forming of the side-surface covering member 20.

The manufacturing method may further include fastening the first cover plate P1 and the second cover plate P2 by the fastening member 30 without (e.g., configured to avoid) interference with the side-surface covering member 20. As the application area (or covering area) of the side-surface covering member 20 is limited or defined by the first protective layer PL1 and the second protective layer PL2 removed, in consideration of a position of the first cover plate P1 to which the fastening member 30 is fastened, the first protective layer PL1 may be attached to the first cover plate P1 and may be removed, and in consideration of a position of the second cover plate P2 to which the fastening member 30 is fastened, the second protective layer PL2 may be attached onto the second cover plate P2 or the light-blocking material layer BM and may be removed.

In the second embodiment, the step portion SP, as a step structure formed between the first protective layer PL1 and the first cover plate P1, may have a step identical to the thickness of the first protective layer PL1. The application area of the side-surface covering member 20 may be limited or defined by the step portion SP.

In the second embodiment, the protrusion portion PP, as a step structure formed between the second protective layer PL2 and the second cover plate P2, may have a step portion having a thickness identical to the thickness of the second protective layer PL2. The area in which the side-surface covering member 20 is applied (or formed) may be limited or defined by the protrusion portion PP.

The first protective layer PL1 may be attached to the top surface (or upper surface) of the first cover plate P1. The first protective layer PL1 may protect at least a portion of the top surface (or upper surface) of the first cover plate P1 from foreign materials, foreign impacts, or the like. The first protective layer PL1 may be removed during the manufacturing process. The first protective layer PL1 may be removed after application of the side-surface covering member 20, before fastening the first cover plate P1 and the fastening member 30 to each other.

For example, the first protective layer PL1 may include at least one from among a pressure-sensitive adhesive (PSA), an optical clear adhesive (OCA), or an optical clear resin (OCR), and may include a pressure-sensitive adhesive having weak adhesion.

The second protective layer PL2 may be disposed on the top surface (or upper surface) of the second cover plate P2. For example, the second protective layer PL2 may be arranged in the non-overlap area NCA. Accordingly, the second protective layer PL2 may be disposed on the light-blocking material layer BM arranged in the non-overlap area NCA. The second protective layer PL2 may protect at least a portion of the top surface (or upper surface) of the second cover plate P2 from foreign materials, foreign impacts, or the like. The second protective layer PL2 may be removed during the manufacturing process. The second protective layer PL2 may be removed after application of the side-surface covering member 20, before fastening the second cover plate P2 and the fastening member 30 to each other.

The first protective layer PL1 may function as the step portion SP in the first embodiment described above. The first protective layer PL1 may limit or define the application area of the side-surface covering member 20 such that the side-surface covering member 20 may not exceed a certain range of the top surface (or upper surface) of the first cover plate P1 in case that the side-surface covering member 20 is formed or applied.

In case that the side-surface covering member 20 is applied or formed, the application area of the side-surface covering member 20 may be limited or defined by the first protective layer PL1, and accordingly, a shape of the edge portion 21 of the side-surface covering member 20 may correspond to a shape of the side surface of the first protective layer PL1. For example, the edge portion 21 of the side-surface covering member 20 may be disposed on the top surface (or upper surface) of the first cover plate P1. As the shape of the edge portion 21 of the side-surface covering member 20 corresponds to the shape of the side surface of the first protective layer PL1, after the first protective layer PL1 is removed, the edge portion 21 of the side-surface covering member 20 may have step portions with respect to the top surface (or upper surface) of the first cover plate P1.

The second protective layer PL2 may function as the protrusion portion PP in the first embodiment described above. The second protective layer PL2 may limit or define the application area of the side-surface covering member 20 such that the side-surface covering member 20 may not exceed a certain range of the top surface (or upper surface) of the second cover plate P2 in case that the side-surface covering member 20 is formed or applied.

In case that the side-surface covering member 20 is applied or formed, the application area of the side-surface covering member 20 may be limited or defined by the second protective layer PL2, and accordingly, a shape of the other edge portion 22 of the side-surface covering member 20 may correspond to a shape of the side surface of the second protective layer PL2. For example, the other edge portion 22 of the side-surface covering member 20 may be disposed on the top surface (or upper surface) of the second cover plate P2, and may be arranged in the non-overlap area NCA. As the shape of the other edge portion 22 of the side-surface covering member 20 corresponds to the shape of the side-surface of the second protective layer PL2, after the second protective layer PL2 is removed, the other edge portion 22 of the side-surface covering member 20 may have step portions with respect to the top surface (or upper surface) of the second cover plate P2 or the top surface (or upper surface) of the light-blocking material layer BM. In another example, the light-blocking material layer BM may be arranged between the other edge portion 22 of the side-surface covering member 20 and the top surface (or upper surface) of the second cover plate P2, and the other edge portion 22 of the side-surface covering member 20 may be disposed on the light-blocking material layer BM.

For example, the side-surface covering member 20 may cover a portion of the top surface (or upper surface) of the second cover plate P2, and the other edge portion 22 of the side-surface covering member 20 may have step portions with respect to the top surface (or upper surface) of the second cover plate P2.

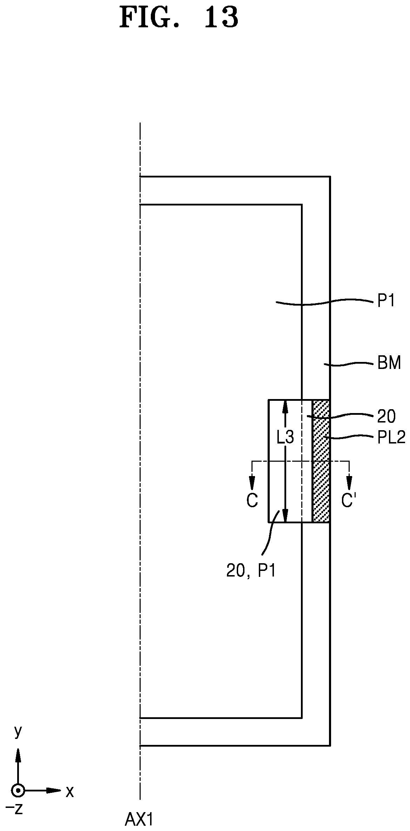

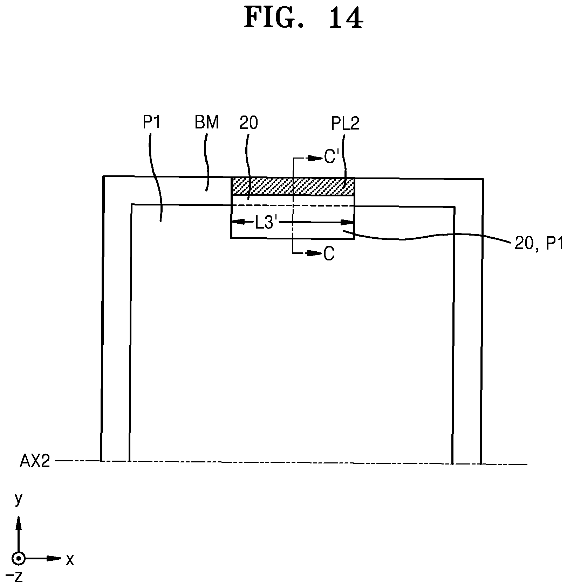

FIG. 13 is a schematic plan view schematically illustrating an example in which a structure shown in the schematic cross-sectional view of FIG. 11 is applicable to the display panel only partially illustrated with reference to the first axis shown in FIG. 1, and FIG. 14 is a schematic plan view schematically illustrating another example in which the structure shown in the schematic cross-sectional view of FIG. 8 is applicable to the display panel only partially illustrated with reference to the second axis shown in FIG. 1.

From descriptions with reference to FIGS. 13 and 14, same or repeated descriptions as the descriptions written above may be omitted for descriptive convenience. For example, a cross-section taken along line C-C' shown in FIG. 13 may have the structure shown in FIG. 11, and a cross-section taken along line C-C' shown in FIG. 14 may also have the structure shown in FIG. 11.

As shown in FIG. 13, the first protective layer PL1 and the second protective layer PL2, which limit or define the application area of the side-surface covering member 20, is viewed in plan view.

Although an example of a portion of the display panel 10 is shown with reference to the first axis AX1, the structure shown in the schematic cross-sectional view of FIG. 11 may also be applicable to other omitted portions. For example, in case that the display panel 10 has a square shape including four sides, the structure shown in the schematic cross-sectional view of FIG. 11 may be applicable to only one side with reference to the first axis AX1. For example, in case that the display panel 10 has a square shape including four sides, the structure shown in the schematic cross-sectional view of FIG. 11 may be applicable to two sides of the display panel 10 with reference to the first axis AX1. For example, in case that the display panel 10 has a square shape including four sides, the structure shown in the schematic cross-sectional view of FIG. 11 may be applicable to all of the four sides.

The side-surface covering member 20 may cover a portion of the top surface (or upper surface) of the first cover plate P1, and the application area of the side-surface covering member 20 may be limited or defined by the first protective layer PL1. In plan view, in the x-axis direction, the application area of the side-surface covering member 20 may be limited or defined by the first protective layer PL1 and the second protective layer PL2. In plan view, in the y-axis direction, the application area of the side-surface covering member 20 may have a third width L3. The third width L3 may include a width of the side-surface covering member 20 measured along the y-axis in plan view. For example, the third width L3 may be substantially identical or similar to a width of a recessed area of the first protective layer PL1, the width measured along the y-axis in plan view. Application characteristics of the side-surface covering member 20 may be clearly understood based on the descriptions with reference to FIGS. 6 and 7.

For example, the third width L3 may be about 3 mm or greater but not greater than the length of the side of the display panel 10 on which the side-surface covering member 20 is applied (or formed). In case that the third width L3 is less than about 3 mm, the first fastening portion 31 and the second fastening portion 32 may not be firmly fastened to the display panel 10. In case that the third width L3 is greater than a length of a side of the display panel 10, it is required that the first fastening portion 31 and the second fastening portion 32 are designed to be greater than the display panel 10, which causes unnecessary consumption of space and materials.

The side-surface covering member 20 may be formed to have a width identical to a width along the y-axis of a recessed area of the first protective layer PL1, and in another example, there may be differences caused due to errors in the application process. In other areas, the light-blocking material layer BM may be viewed in plan view. Although descriptions of the first fastening portion 31 and the second fastening portion 32 are omitted for convenience of explanation, descriptions of the first fastening portion 31 and the second fastening portion 32 may be clearly understood based on the descriptions with reference to FIGS. 6 and 7. In FIG. 13, the side-surface covering member 20 still may be applied (or formed) mainly in the areas corresponding to the first fastening portion 31 and the second fastening portion 32.

As shown in FIG. 10, the first protective layer PL1 and the second protective layer PL2, which limit or define the application area of the side-surface covering member 20, are viewed in plan view.

Although an example of a portion of the display panel 10 is shown with reference to the second axis AX2, the structure shown in the schematic cross-sectional view of FIG. 11 may also be applicable to other omitted portions. For example, in case that the display panel 10 has a square shape including four sides, the structure shown in the schematic cross-sectional view of FIG. 11 may be applicable to only one side with reference to the second axis AX2. For example, in case that the display panel 10 has a square shape including four sides, the structure shown in the schematic cross-sectional view of FIG. 11 may be applicable to two sides of the display panel with reference to the second axis AX2. For example, in case that the display panel 10 has a square shape including four sides, the structure shown in the schematic cross-sectional view of FIG. 11 may be applicable to all of the four sides.

The side-surface covering member 20 may cover a portion of the top surface (or upper surface) of the first cover plate P1, and the application area of the side-surface covering member 20 may be limited or defined by the first protective layer PL1. In plan view, in the y axis direction, the application area of the side-surface covering member 20 may be limited or defined by the first protective layer PL1 and the second protective layer PL2. In plan view, in the x-axis direction, the application area of the side-surface covering member 20 may have a third width L3'. The third width L3' may include a width of the side-surface covering member 20 measured along the x-axis in plan view. For example, the third width L3' may be substantially or similar to a width of a recessed area of the first protective layer PL1, the width measured along the x-axis in plan view. Application characteristics of the side-surface covering member 20 may be clearly understood based on the descriptions with reference to FIGS. 6 and 7.

For example, the third width L3' may be about 3 mm or greater but not greater than a length of a side of the display panel 10 on which the side-surface covering member 20 is applied (or formed). In case that the third width L3' is less than about 3 mm, the first fastening portion 31 and the second fastening portion may not be firmly fastened to the display panel 10. In case that the third width L3' is greater than the length of the side of the display panel 10, it is required that the first fastening portion 31 and the second fastening portion 32 are designed to be greater than the display panel 10, which causes unnecessary consumption of space and materials.

The side-surface covering member 20 may be formed to have a width identical to a width along the x-axis of a recessed area of the first protective layer PL1, and in another example, there may be differences caused due to errors in an application process. In other areas, the light-blocking material layer BM may be viewed in plan view. Although descriptions of the first fastening portion 31 and the second fastening portion 32 are omitted for convenience of explanation, descriptions of the first fastening portion 31 and the second fastening portion 32 may be clearly understood based on the descriptions with reference to FIGS. 6 and 7. In FIG. 14, the side-surface covering member 20 still may be applied (or formed) mainly in the areas corresponding to the first fastening portion 31 and the second fastening portion 32.

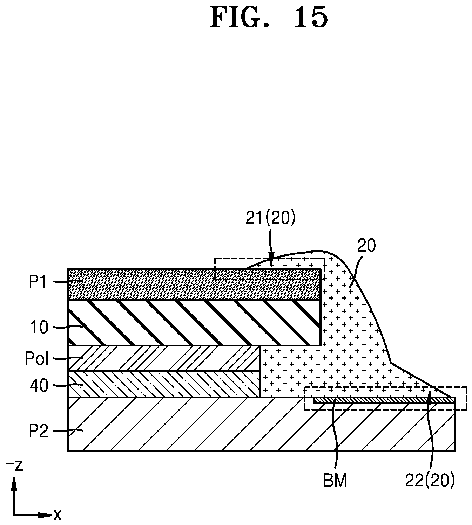

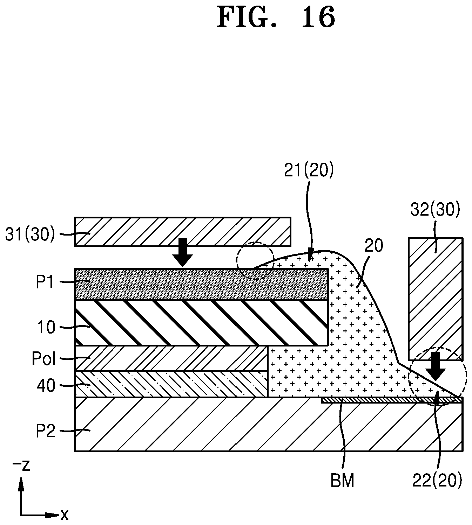

FIGS. 15 and 16 are cross-sectional views each schematically illustrating a portion of a display apparatus according to a comparative example. From descriptions of the display apparatus with reference to FIGS. 15 and 16, same or repeated descriptions as the descriptions written above may be omitted for descriptive convenience.

As shown in FIG. 15, the side-surface covering member 20 of the display apparatus according to the comparative example may be applied (or formed) on the top surface (or upper surface) of the first cover plate P1. The application area of the side-surface covering member 20, which is formed on the top surface (or upper surface) of the first cover plate P1, is not limited by step portions and the like, and therefore, the side-surface covering member 20 may be widely applied (or formed) along the top surface (or upper surface) of the first cover plate P1.

As shown in FIG. 15, the side-surface covering member 20 of the display apparatus according to the comparative example may be applied (or formed) in a portion of the top surface (or upper surface) of the second cover plate P2 or on the light-blocking material layer BM disposed on the second cover plate P2. As the application area of the side-surface covering member 20, which is formed on the top surface (or upper surface) of the second cover plate P2 or on the light-blocking material layer BM, may not be limited by the step portions and the like, and therefore, the side-surface covering member 20 may be widely applied (or formed) along the top surface (or upper surface) of the second cover plate P2 or the top surface (or upper surface) of the light-blocking material layer BM.

As shown in FIG. 16, an edge portion 21 of the side-surface covering member of the display apparatus according to the comparative example may be disposed on the first cover plate P1, and may be interfered with the fastening member 30 in case that fastened with the fastening member 30. For example, the first fastening portion 31 of the fastening member 30, which is fastened to the first cover plate P1, and the edge portion of the side-surface covering member 20 may be interfered with each other.

As shown in FIG. 16, another edge portion 22 of the side-surface covering member 20 of the display apparatus according to the comparative example may be disposed on the second cover plate P2, and may be interfered with the fastening member 30 in case that the another edge portion 22 of the side-surface covering member 20 of the display apparatus is fastened to the fastening member 30. For example, the second fastening portion 32 of the fastening member 30, which is fastened to the second cover plate P2, and the other edge portion of the side-surface covering member 20 may be interfered with each other.

Due to the interference, the fastening member 30 may not be properly fastened to the display panel 10. To solve the aforementioned problem, a position for fastening the fastening member 30 or a position of the application area of the side-surface covering member 20 may be changed. However, in case that the position for fastening the fastening member 30 or the application area of the side-surface covering member 20 is changed, the side-surface covering member 20 may not be applied (or formed) at a most suitable position. Thus, the stability and reliability of the display apparatus may be degraded. Therefore, it is important that the side-surface covering member 20 is applied or formed by a method by which interference is prevented.

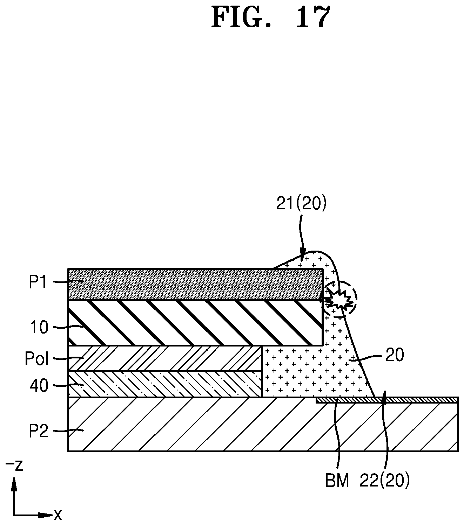

FIG. 17 is a schematic cross-sectional view schematically illustrating a portion of a display apparatus according to another comparative example. From the descriptions of the display apparatus with reference to FIG. 17, same or repeated descriptions as the descriptions written above may be omitted for descriptive convenience.

To minimize interference caused by the side-surface covering member 20 shown in FIGS. 15 and 16, an amount of the material included in the side-surface covering member 20 may be reduced, as shown in FIG. 17. As a result, the application area of the side-surface covering member 20 may be reduced.

As shown in FIG. 17, in case that a material of a less amount is applied to apply or form the side-surface covering member 20, the application area of the side-surface covering member 20 covering the top surface (or upper surface) of the first cover plate P1 may be reduced. However, due to reduction of a thickness of the side-surface covering member 20, the display panel 10 may not be effectively protected. In another example, a portion of a side surface of the display panel 10 or a side surface of the first cover plate P1 may be exposed outside. Accordingly, it is required that the side-surface covering member 20 is formed using a sufficient amount of material but the application area of the side-surface covering member 20 is limited or defined.

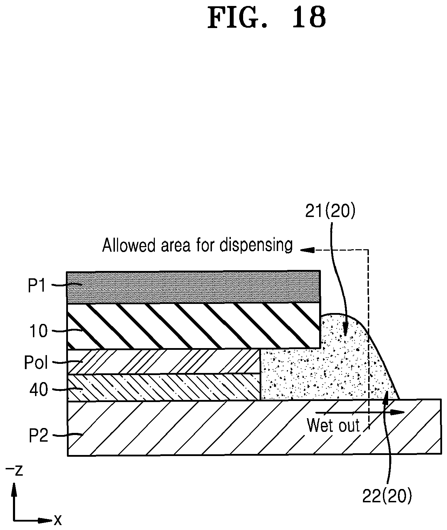

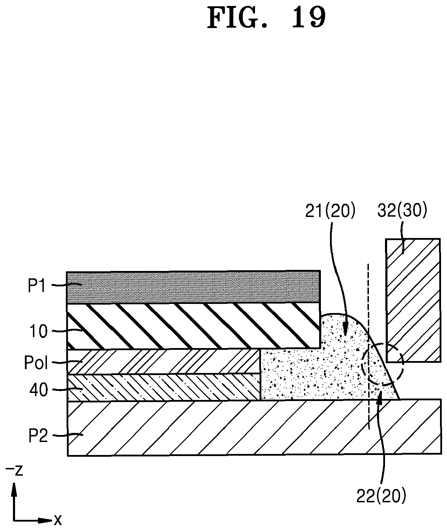

FIGS. 18 and 19 are cross-sectional views each schematically illustrating a portion of a display apparatus according to another comparative example. From descriptions of the display apparatus with reference to FIGS. 18 and 19, same or repeated descriptions as the descriptions written above may be omitted for descriptive convenience.

As shown in FIG. 8, the side-surface covering member 20 of the display apparatus according to the other embodiment may not reach (or cover) the top surface (or upper surface) of the first cover plate P1 and may only cover at least a portion of the side surface of the display panel 10. For example, the side-surface covering member 20 may function as a corner sealing portion by using a resin and the like.

As shown in FIG. 19, an edge portion 21 of the side-surface covering member 20 of the display apparatus according to the other comparative example may contact the side surface of the display panel 10, and another edge portion 22 of the side-surface covering member 20 of the display apparatus according to the other comparative example may be disposed on the second cover plate P2. The other edge portion 22 of the side-surface covering member 20 may be interfered with the fastening member 30 in case that the fastening member 30 is fastened. For example, the second fastening portion 32 of the fastening member 30, which is fastened to the first cover plate P1, and the other edge portion of the side-surface covering member 20 may be interfered with each other.

Due to the interference, the fastening member 30 may not be properly fastened to the display panel 10. To solve the aforementioned problem, a position for fastening the fastening member 30 is fastened or a position of the application area of the side-surface covering member 20 may be changed. However, in case that the position for fastening the fastening member 30 or the application area of the side-surface covering member 20 is changed, the side-surface covering member 20 may not be applied (or formed) at a most suitable position. Thus, the stability and reliability of the display apparatus may be degraded. Therefore, it is important that the side-surface covering member 20 is applied or formed by a method by which interference is prevented.

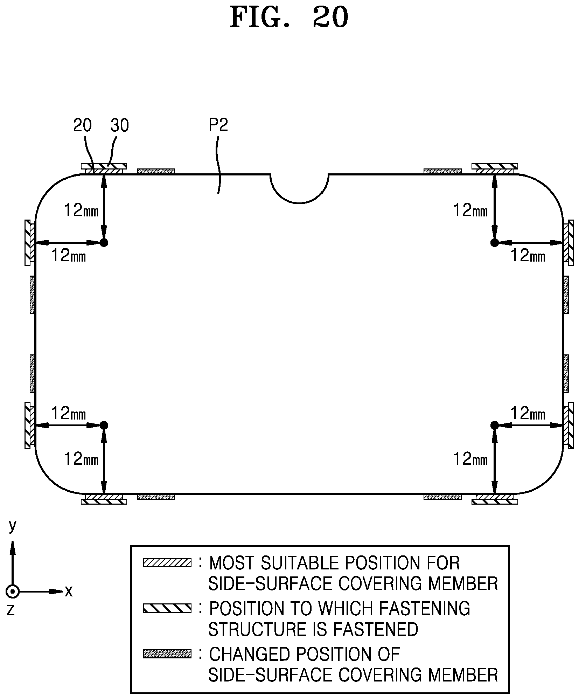

FIG. 20 is a schematic rear view schematically illustrating a display apparatus according to a first embodiment or a second embodiment. From the descriptions of the display apparatus with reference to FIG. 20, same or repeated descriptions as the descriptions written above may be omitted for descriptive convenience.

As shown in FIG. 20, a most suitable position of the side-surface covering member 20 and the position for fastening the fastening member 30 may overlap each other. For example, interference may occur between the fastening member 30 and the side-surface covering member 20.

Therefore, to prevent the interference, the position for fastening the fastening member 30 or the position for applying the side-surface covering member 20 may be changed. However, for example, it was unable to fasten the fastening member 30 or arrange the side-surface covering member 20 at a most suitable position. For example, to improve aesthetic sensibility, it may be required that the fastening member 30 is fastened to particular positions. In another example, it may be required that the fastening member 30 is fastened to particular positions to satisfy requests of a customer company. Accordingly, in general, a position for applying the side-surface covering member 20 may be changed to prevent interference.

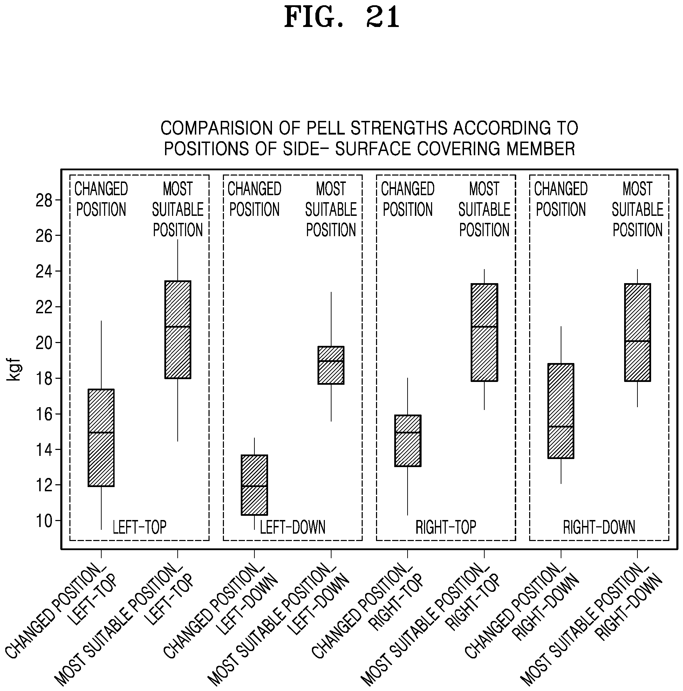

FIG. 21 is a graph showing a result of comparing peel strengths according to positions of the side-surface covering member 20 of the display apparatus shown in FIG. 20.

As shown in FIG. 21, difference in peel strengths according to the positions of the side-surface covering member 20 is recognized. For example, the side-surface covering members 20 may be applied (or formed) at four positions, and the four positions may be divided into left-up, left-down, right-up, and right-down. It is recognized that the peel strength at the most suitable position of the side-surface covering member 20 shown in FIG. 20 is much greater than the peel strength at a changed position of the side-surface covering member 20 shown in FIG. 14.

Therefore, it is required that the application area of the side-surface covering member 20 is limited or defined to avoid interference in case that the most suitable position of the side-surface covering member 20 and the position for fastening the fastening member 30 overlaps each other.

According to one or more embodiments of the disclosure, a display apparatus capable of preventing interference between the side-surface covering member 20 applied (or formed) to the side surface of the display panel 10 and the fastening member 30 and a method of manufacturing the display apparatus may be implemented. However, the scope of the invention is not limited thereto.

In concluding the detailed description, those skilled in the art will appreciate that many variations and modifications may be made to the embodiments without substantially departing from the scope of the disclosure as defined by the appended claims and equivalents thereto. Therefore, the disclosed embodiments are used in a generic and descriptive sense only and not for purposes of limitation.

## Claims

1. A display apparatus comprising:
a display panel (10);
a first cover plate (P1) covering an upper surface of the display panel (10) and comprising a step portion (SP) disposed at an edge portion of the first cover plate (P1);
a second cover plate (P2) covering a lower surface of the display panel (10);
a protrusion portion (PP) disposed on an upper surface of the second cover plate (P2) and not overlapping the first cover plate (P1) when viewed in a direction perpendicular to the display panel (10); and
a side-surface covering member (20) at least partially covering a portion of a side surface of the display panel (10) which is exposed between the step portion (SP) and the protrusion portion (PP).

2. The display apparatus of claim 1, wherein the step portion (SP) has a step shape having a height decreasing from inside the first cover plate (P1) toward outside the first cover plate (P1).

3. The display apparatus of claim 1 or 2, wherein a covering area of the side-surface covering member (20) is partially defined by an inner surface of the step portion (SP) and an outer surface of the protrusion portion (PP).

4. The display apparatus of any one of the preceding claims, wherein the protrusion portion (PP) protrudes with respect to the upper surface of the second cover plate (P2) and comprises a light-blocking material.

5. The display apparatus of any one of the preceding claims,
wherein the side-surface covering member (20) further covers at least a portion of an inner surface of the step portion (SP) and a lower surface of the step portion (SP); and/or
wherein the side-surface covering member (20) further covers a portion of the upper surface of the second cover plate (P2) which is exposed between the display panel (10) and the protrusion portion (PP).

6. The display apparatus of any one of the preceding claims, further comprising:
a fastening member (30) which contacts the first cover plate (P1) and the second cover plate (P2) and is not interfered by the side-surface covering member (20) in case that the fastening member (30) contacts the first cover plate (P1) and the second cover plate (P2).

7. The display apparatus of claim 6,
wherein, in case that the fastening member (30) is fastened, the side-surface covering member (20) is spaced apart from the fastening member (30) by the step portion (SP); and/or
wherein, in case that the fastening member (30) is fastened, the side-surface covering member (20) is spaced apart from the fastening member (30) by the protrusion portion (PP).

8. The display apparatus of any one of the preceding claims, wherein
the second cover plate (P2) comprises a transparent material, and
light emitted from the display panel (10) is transmitted through the second cover plate (P2) and is emitted outside.

9. The display apparatus of any one of the preceding claims, further comprising:
a light-blocking material layer (BM) disposed between the protrusion portion (PP) and the second cover plate (P2) and comprising a light-blocking material,
wherein the protrusion portion (PP) is disposed on the light-blocking material layer (BM).

10. The display apparatus of any one of the preceding claims, wherein, when viewed in a direction perpendicular to the display panel (10), an inner surface of the step portion (SP) is disposed further inward than the side surface of the display panel (10).

11. The display apparatus of any one of the preceding claims, wherein an edge portion (21) of the side-surface covering member (20) contacts at least a portion of an inner surface of the step portion (SP), wherein the edge portion (21) of the side-surface covering member (20) optionally has a shape corresponding to a shape of the inner surface of the step portion (SP).

12. The display apparatus of claim 11, wherein another edge portion (22) of the side-surface covering member (20) contacts at least a portion of the inner surface of the protrusion portion (PP), wherein the another edge portion (22) of the side-surface covering member (20) optionally has a shape corresponding to a shape of the inner surface of the protrusion portion (PP).

13. A display apparatus comprising:
a display panel (10);
a first cover plate (P1) covering an upper surface of the display panel (10);
a second cover plate (P2) covering a lower surface of the display panel (10); and
a side-surface covering member (20) covering at least a portion of a side surface of the display panel (10) and at least a portion of an edge portion of an upper surface of the first cover plate (P1) and including an edge portion (21) having a step portion (SP) on the upper surface of the first cover plate (P1).

14. The display apparatus of claim 13, wherein
the side-surface covering member (20) covers a portion of an upper surface of the second cover plate (P2), and
another edge portion (22) of the side-surface covering member (20) has a step portion (SP) on an upper surface of the second cover plate (P2).

15. The display apparatus of claim 13 or 14, further comprising:
a light-blocking material layer (BM) disposed between the another edge portion (22) of the side-surface covering member (20) and the upper surface of the second cover plate (P2).

16. A method of manufacturing a display apparatus, the method comprising:
attaching a first cover plate (P1) on an upper surface of a display panel (10);
attaching a second cover plate (P2) on a lower surface of the display panel (10) by using an adhesive layer (40);
forming a step portion (SP) by removing a portion of an edge portion of the first cover plate (P1);
forming a protrusion portion (PP) on an upper surface of the second cover plate (P2); and
forming a side-surface covering member (20) by applying a strength-enhancing material on a portion of a side surface of the display panel (10) which is exposed between the step portion (SP) and the protrusion portion (PP).

17. A method of manufacturing a display apparatus, the method comprising:
attaching a first cover plate (P1) on an upper surface of a display panel (10);
attaching a second cover plate (P2) on a lower surface of the display panel (10) by using an adhesive layer (40);
forming a step portion (SP) with respect to an upper surface of the first cover plate (P1) by attaching a first protective layer on the upper surface of the first cover plate (P1), the step portion (SP) and the first protective layer having a same thickness;
forming a protrusion portion (PP) protruding with respect to an upper surface of the second cover plate (P2) by attaching a second protective layer on an area of the upper surface of the second cover plate (P2) which is exposed upward, the protrusion portion (PP) and the second protective layer having a same thickness;
forming a side-surface covering member (20) by applying a strength-enhancing material on a portion of a side surface of the display panel (10) which is exposed between the step portion (SP) and the protrusion portion (PP); and
removing the first protective layer or the second protective layer after the forming of the side-surface covering member (20).

18. The method of claim 16 or 17, wherein, when viewed in a direction perpendicular to the display panel (10), the protrusion portion (PP) is disposed in an area where the first cover plate (P1) and the second cover plate (P2) do not overlap each other.

19. The method of any one of claims 16 to 18,
wherein a covering area of the side-surface covering member (20) on an upper surface of the first cover plate (P1) is limited by the step portion (SP); and/or
wherein a covering area of the side-surface covering member (20) on an upper surface of the second cover plate (P2) is limited by the protrusion portion (PP).

20. The method of any one of claims 16 to 19, further comprising:
fastening the first cover plate (P1) and the second cover plate (P2) by a fastening member (30) without interference with the side-surface covering member (20).
